# EUROPEAN PATENT APPLICATION

(11) **EP 4 730 972 A1**
(43) Date of publication of application: **22.04.2026**
(21) Application number: 23953672.5
(22) Date of filing: 28.09.2023
(51) Int. Cl.: H10K 59/126

(54) **DISPLAY PANEL AND MANUFACTURING METHOD THEREFOR, AND DISPLAY APPARATUS**

(71) Applicant: BOE Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: ZHANG, Wei, Beijing 100176 (CN); DONG, Xiangdan, Beijing 100176 (CN); WANG, Hongli, Beijing 100176 (CN); WU, Tong, Beijing 100176 (CN)
(74) Representative: Brötz, Helmut
(86) International application number: PCT/CN2023/122611
(87) International publication number: WO 2025/065523

(57) **Abstract**

A display panel and a manufacturing method therefor, and a display apparatus. The display panel comprises: a first region; a second region; a third region; a plurality of sub-pixels; a base substrate; and at least one partition structure located on the base substrate. The partition structure is located in the third region, the partition structure comprises a first separation structure and a second separation structure which are stackedly arranged, and the second separation structure is located on the side of the first separation structure away from the base substrate. An edge of the second separation structure protrudes relative to an edge of the first separation structure. The partition structure is configured to partition at least one layer of light-emitting functional layers. The display panel further comprises an insulating layer located on the base substrate. In the third region, at least part of the insulating layer is located on a side wall of the at least one partition structure. The part of the partition structure that is used to achieve the "partition effect" is not covered or filled in by other film layers, so that the second separation structure in the partition structure has an obvious protruding portion, thereby helping to reduce the risk of crosstalk.

## Description

### TECHNICAL FIELD

Embodiments of the present disclosure relate to a display panel and a manufacturing method thereof, and a display apparatus.

### BACKGROUND

Organic light-emitting diode (OLED) display products have advantages such as rich colors, fast response time, and foldability. As display technology advances, user demands for lifespan and power consumption of display apparatuses are increasing. A tandem organic light-emitting display device, by incorporating at least one light-emitting layer and a charge generation layer (CGL), realizes lifespan and luminance improvement and power consumption reduction, thereby meeting users' demands for lifespan and power consumption of display apparatuses.

### SUMMARY

Embodiments of the present disclosure provide a display panel and a manufacturing method thereof, and a display apparatus.

A display panel provided by an embodiment of the present disclosure includes: a first region, a second region, a third region, a plurality of sub-pixels, a base substrate, and at least one partition structure located on the base substrate, in which the first region is configured to display; the second region is configured to transmit light, the first region is located on at least one side of the second region; the third region is located between the first region and the second region; the plurality of sub-pixels are located in the first region, each sub-pixel of at least some sub-pixels includes a light-emitting functional layer, and the light-emitting functional layer includes a plurality of film layers; and the partition structure is located in the third region and includes a first isolation structure and a second isolation structure which are arranged in a layered way, the second isolation structure is located on a side of the first isolation structure away from the base substrate, an edge of the second isolation structure protrudes relative to an edge of the first isolation structure, and the partition structure is configured to partition at least one layer of the light-emitting functional layer; the display panel further includes an insulation layer located on the base substrate, and in the third region, at least a portion of the insulation layer is located on a side wall of the at least one partition structure.

For example, according to the display panel provided by the embodiment of the present disclosure, the second isolation structure includes a protrusion portion which protrudes relative to the edge of the first isolation structure, and the at least a portion of the insulation layer located on the side wall of the partition structure and the protrusion portion of the partition structure are spaced apart from each other in a direction perpendicular to the base substrate.

For example, according to the display panel provided by the embodiment of the present disclosure, at least a portion of the insulation layer is located on a side wall of the first isolation structure; and/or the partition structure further includes a third isolation structure located on a side of the first isolation structure close to the base substrate, and at least a portion of the insulation layer is located on a side wall of the third isolation structure.

For example, according to the display panel provided by the embodiment of the present disclosure, the partition structure further includes a third isolation structure located on a side of the first isolation structure close to the base substrate, the first isolation structure, the second isolation structure and the third isolation structure all include metal materials, the material of the first isolation structure is different from that of the second isolation structure, and the material of the second isolation structure is the same as that of the third isolation structure; or the materials of the first isolation structure, the second isolation structure and the third isolation structure are different.

For example, according to the display panel provided by the embodiment of the present disclosure, the display panel further includes at least one layer of metal structure located between the partition structure and the base substrate, and in the third region, an orthographic projection of the partition structure on the base substrate falls within an orthographic projection of the at least one layer of metal structure on the base substrate.

For example, according to the display panel provided by the embodiment of the present disclosure, the at least one layer of metal structure includes a first metal structure and a second metal structure which are arranged in a layered way; and in the third region, the first metal structure, the second metal structure and the partition structure are sequentially arranged in a layered way in a direction perpendicular to the base substrate, and the partition structure is located on a side of the second metal structure away from the base substrate.

For example, according to the display panel provided by the embodiment of the present disclosure, the orthographic projection of the partition structure on the base substrate falls within an orthographic projection of the second metal structure on the base substrate.

For example, according to the display panel provided by the embodiment of the present disclosure, the display panel further includes a pixel defining pattern and a defining structure, the pixel defining pattern is located in the first region and on the base substrate, the pixel defining pattern comprising a plurality of first openings to define light-emitting regions of at least some of the sub-pixels; and the defining structure is located in the first region and between the light-emitting functional layer and the base substrate, the defining structure includes a portion surrounding the light-emitting region of each of the at least some of the sub-pixels, the pixel defining pattern further includes a second opening, a portion of at least one layer of the light-emitting functional layer located in the first opening is a continuous portion, at least a potion located in at least one second opening is partitioned, and the portion exposed by the second opening in the defining structure is configured to partition the at least one layer of the light-emitting functional layer.

For example, according to the display panel provided by the embodiment of the present disclosure, the defining structure includes a first sub-defining structure and a second sub-defining structure which are arranged in a layered way, the first sub-defining structure is located at a side of the second sub-defining structure close to the base substrate, and an edge of the second sub-defining structure protrudes relative to an edge of the first sub-defining structure; and a portion, located in the first region, of the insulation layer includes at least one of the first sub-defining structure and the second sub-defining structure.

For example, according to the display panel provided by the embodiment of the present disclosure, the portion, located in the first region, of the insulation layer includes the first sub-defining structure, and at least a portion of the insulation layer covers an outer wall of the first metal structure and an outer wall of the second metal structure.

For example, according to the display panel provided by the embodiment of the present disclosure, an average thickness of the portion, covering the outer wall of the first metal structure and the outer wall of the second metal structure, of the insulation layer is a first thickness, an average thickness of the first sub-defining structure located in the first region of the insulation layer is a second thickness, and the first thickness is smaller than the second thickness.

For example, according to the display panel provided by the embodiment of the present disclosure, the first thickness is 1/100 to 1/10 of the second thickness.

For example, according to the display panel provided by the embodiment of the present disclosure, the display panel includes a plurality of the partition structures arranged at intervals, and the partition structure presents a shape of a ring and surrounds the second region; and in the third region, at least a portion of the base substrate between adjacent partition structures is not overlapped with the insulation layer.

For example, according to the display panel provided by the embodiment of the present disclosure, each of the at least some sub-pixels further includes a first electrode and a second electrode which are located on two sides of the light-emitting functional layer in the direction perpendicular to the base substrate, the first electrode is located between the light-emitting functional layer and the base substrate, the pixel defining pattern is located on a side of the first electrode away from the base substrate, and the second sub-defining structure is located between the first electrode and the base substrate; and the display panel further includes a pixel circuit located on a side of the first sub-defining structure close to the base substrate, and the pixel circuit is electrically connected with the first electrode.

For example, according to the display panel provided by the embodiment of the present disclosure, a film layer where the first sub-defining structure is located includes a connection via hole, the pixel circuit is electrically connected with the first electrode through the connection via hole, and at least a portion of the second sub-defining structure extends into the connection via hole and covers a side wall of the connection via hole.

For example, according to the display panel provided by the embodiment of the present disclosure, a material of the first sub-defining structure is different from that of the second sub-defining structure, the material of the first sub-defining structure includes an organic material or an inorganic non-metallic material, and the material of the second sub-defining structure includes an inorganic non-metallic material or a metallic material.

For example, according to the display panel provided by the embodiment of the present disclosure, for a same etching solution, an etching selectivity of the first isolation structure, an etching selectivity of the first sub-defining structure and an etching selectivity of the second sub-defining structure decrease in sequence.

At least one embodiment of the present disclosure further provides a display apparatus, which includes the display panel described in any one of the above.

At least one embodiment of the present disclosure further provides a manufacturing method of a display panel, the display panel includes a first region, a second region and a third region located between the first region and the second region, the first region is configured to display, the second region is configured to transmit light, and the first region is located on at least one side of the second region; and the manufacturing method includes: performing patterning in the third region to form an initial partition structure on a base substrate, the initial partition structure comprising a first sub-isolation structure and a second isolation structure which are arranged in a layered way, the first sub-isolation structure being closer to the base substrate than the second isolation structure, and in a direction perpendicular to the base substrate, an edge of the first sub-isolation structure being approximately flush with an edge of the second isolation structure; forming a first defining layer on a side of the initial partition structure away from the base substrate, and patterning the first defining layer to form a first sub-defining portion, and in the third region, the first sub-defining portion covering a side surface of the initial partition structure and an upper surface of the initial partition structure away from the base substrate; forming a second defining layer on a side of the first sub-defining portion away from the base substrate, and patterning the second defining layer and the first sub-defining portion to expose at least a portion of the initial partition structure; and patterning the initial partition structure to form a partition structure, wherein the partition structure includes a first isolation structure and a second isolation structure which are arranged in a layered way, the second isolation structure is located on a side of the first isolation structure away from the base substrate, an edge of the second isolation structure protrudes relative to an edge of the first isolation structure, the partition structure is configured to partition at least one layer of a light-emitting functional layer of a sub-pixel, and in the third region, a side wall of at least one partition structure is covered with at least one of at least a portion of the second defining layer and at least a portion of the first sub-defining portion.

For example, according to the manufacturing method of a display panel provided by the embodiment of the present disclosure, patterning the first defining layer to form a first sub-defining portion includes: in the third region, removing a portion of the first defining layer between adjacent initial partition structures; and thinning a portion of the first defining layer covering the side surface and the upper surface of the initial partition structure.

For example, according to the manufacturing method of a display panel provided by the embodiment of the present disclosure, in the third region, the first defining layer is patterned with a halftone mask, so as to thin the portion of the first defining layer covering the side surface and the upper surface of the initial partition structure while removing the portion of the first defining layer between adjacent initial partition structures, and a thickness of the first defining layer after thinning is 100-10000 Å.

For example, according to the manufacturing method of a display panel provided by the embodiment of the present disclosure, both of the formed second defining layer and the formed first sub-defining portion include a portion located in the first region, and patterning the second defining layer and the first sub-defining portion to expose the initial partition structure includes: patterning the second defining layer and the first sub-defining portion at the same time, so as to remove the second defining layer in the third region while forming a defining structure in the first region, and remove at least a portion of the first sub-defining portion covering the side surface and the upper surface of the initial partition structure, wherein the defining structure includes a first sub-defining structure and a second sub-defining structure which are arranged in a layered way, the first sub-defining structure is located at a side of the second sub-defining structure close to the base substrate, and an edge of the second sub-defining structure protrudes relative to an edge of the first sub-defining structure.

For example, according to the manufacturing method of a display panel provided by the embodiment of the present disclosure, in the third region, a portion of the first sub-defining portion covering the upper surface of the initial partition structure is removed, and a portion of the first sub-defining portion covering a side surface of the first sub-isolation structure in the initial partition structure is largely removed.

For example, according to the manufacturing method of a display panel provided by the embodiment of the present disclosure, before forming the initial partition structure on the base substrate, the manufacturing method further includes: performing patterning to form at least one layer of metal structure in the third region, wherein the metal structure and the initial partition structure are arranged in a layered way, the metal structure is closer to the base substrate than the initial partition structure, and an orthographic projection of the initial partition structure on the base substrate falling within an orthographic projection of the metal structure on the base substrate.

For example, according to the manufacturing method of a display panel provided by the embodiment of the present disclosure, patterning the first defining layer to form a first sub-defining portion further includes: thinning a portion of the first defining layer covering a surface of the metal structure in the third region; and patterning the second defining layer and the first sub-defining portion to expose the initial partition structure further includes: patterning the second defining layer and the first sub-defining portion at the same time, so that the portion of the first defining layer covering the surface of the metal structure is preserved in the third region.

### BRIEF DESCRIPTION OF DRAWINGS

Fig. 1 is a plan view of a display panel provided by at least one embodiment of the present disclosure.
Fig. 2 is a partial cross-sectional view taken along a line W1-W1' illustrated in Fig. 1.
Fig. 3 is a schematic diagram of a first region of a display panel illustrated in Fig. 1 in an example.
Fig. 4 is a partial cross-sectional view taken along a line W2-W2' illustrated in Fig. 3.
Fig. 5 is a partial enlarged view of a connection via hole N1 in Fig. 2.
Fig. 6 is a structural diagram of a first region of a display panel illustrated in Fig. 1 in another example.
Fig. 7 is a structural diagram of a first region of a display panel illustrated in Fig. 1 in still another example.
Fig. 8 is a structural diagram of a first region of a display panel illustrated in Fig. 1 in still another example.
Fig. 9 is a schematic diagram of a first region of a display panel illustrated in Fig. 1 in still another example.
Fig. 10 is a schematic diagram of a first region of a display panel illustrated in Fig. 1 in still another example.
Fig. 11 is a schematic diagram of a first region of a display panel illustrated in Fig. 1 in still another example.
Fig. 12 is a schematic diagram of a first region of a display panel illustrated in Fig. 1 in still another example.
Fig. 13 is a schematic diagram of a first region of a display panel illustrated in Fig. 1 in still another example.
Fig. 14 to Fig. 20 are flowcharts of a manufacturing method of a display panel provided by an embodiment of the present disclosure.
Fig. 21 is a partial plan structural view of a display panel provided by an embodiment of the present disclosure.
Fig. 22 is a partial enlarged structural view of a region in Fig. 21.

### DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure. It is obvious that the described embodiments are just a part but not all of the embodiments of the disclosure. Based on the described embodiments herein, those skilled in the art can obtain other embodiment(s), without any inventive work, which should be within the scope of the disclosure.

Unless otherwise specified, the technical terms or scientific terms used in the disclosure shall have normal meanings understood by those skilled in the art. The words "first", "second" and the like used in the disclosure do not indicate the sequence, the number or the importance but are only used for distinguishing different components. The word "comprise", "include" or the like only indicates that an element or a component before the word contains elements or components listed after the word and equivalents thereof, not excluding other elements or components.

As used in embodiments of the present disclosure, the features "parallel", "perpendicular", and "identical" etc. include the features "parallel", "perpendicular", and "identical," etc. in the strict sense, as well as "approximately parallel", "approximately perpendicular", and "approximately identical," etc., which include a certain amount of error, and are indicated to be within a range of acceptable deviations for a particular value as determined by a person of ordinary skill in the art, taking into account the measurement and the error associated with the measurement of the particular quantity (e.g., the limitation of the measurement system). For example, "approximately" can mean within one or more standard deviations, or within 10% or 5% of the stated value. Upon the quantity of a component being not specified in the following of the embodiment of the present disclosure, it means that the component can be one or more, or can be understood as at least one. "At least one" means one or more, and "a plurality of" means at least two.

Usually, a display panel having a "pinhole screen" usually includes a display region used for normal display and a hollow region used for arranging a sensor (e.g., a camera). The display region used for normal display usually includes a light-emitting element and a pixel circuit; the pixel circuit is electrically connected with the light-emitting element, and the pixel circuit is configured to drive the light-emitting element to emit light. The sensor is usually arranged in the hollow region; the hollow region is a region where a material is removed as compared with the normal display region, to facilitate the sensor to receive external ambient light. Therefore, the display panel having the "pinhole screen" is different from a display panel having a "full screen"; and the hollow region of the display panel having the "pinhole screen" has good transparency performance.

A Tandem device has characteristics of low power consumption and long lifespan. With respect to the Tandem device, a light-emitting functional layer in a light-emitting element may include a plurality of film layers stacked; however, there is a charge generation layer (CGL) arranged between at least two layers of the plurality of film layers in the Tandem device, and conductivity of the charge generation layer (CGL) is relatively great, so, upon the charge generation layer (CGL) being a whole-face film layer, the charge generation layer (CGL) of two adjacent light-emitting elements is a continuous film layer. Thus, a phenomenon of lateral migration of charges easily occurs, causing monochromatic chromaticity shift of the display panel in a low gray scale, which easily causes crosstalk between adjacent sub-pixels, leading to color cast of the display panel.

**In** study, an inventor of the present application found that in order to reduce the risk of crosstalk between sub-pixels of different colors, it is necessary to isolate at least one film layer in a light-emitting functional layer between the sub-pixels of different colors, and in order to ensure an isolation effect on film layers such as the light-emitting functional layer, it is necessary to further arrange a partition structure in an edge region of the display region, so as to further isolate the film layers such as the light-emitting functional layer in the edge region of the display region to reduce the crosstalk phenomenon. **In** some display panels, a manufacturing process of the partition structure close to the edge region of the display region is cumbersome, and a process accuracy is difficult to control. For example, in the process of manufacturing the partition structure, residues of materials from other film layers may remain close to an "undercut" structure of the partition structure, which may weaken a "partition characteristic" of the partition structure, resulting in poor isolation effect of the partition structure.

At least one embodiment of the present disclosure provides a display panel and a manufacturing method thereof, and a display apparatus.

The display panel provided by at least one embodiment of the present disclosure includes a first region, a second region, a third region, a plurality of sub-pixels, a base substrate and at least one partition structure located on the base substrate; the first region is configured to display; the second region is configured to transmit light, and the first region is located on at least one side of the second region; the third region is located between the first region and the second region; the plurality of sub-pixels are located in the first region, and at least some of the sub-pixels each include a light-emitting functional layer, and the light-emitting functional layer includes a plurality of film layers; the partition structure is located in the third region and includes a first isolation structure and a second isolation structure which are arranged in a layered way, the second isolation structure is located on a side of the first isolation structure away from the base substrate, an edge of the second isolation structure protrudes relative to an edge of the first isolation structure, and the partition structure is configured to isolate at least one layer of the light-emitting functional layer; and the display panel further includes an insulation layer located on the base substrate, and in the third region, at least a portion of the insulation layer is located on a side wall of each of the at least one partition structure.

The partition structure in the display panel provided by at least one embodiment of the present disclosure is simple in structure, and its manufacturing process is easy to control; a portion intended to partition within the partition structure is not covered or filled by other film layers, and only a part of the insulation layer that has not been completely removed remains on the side wall of the partition structure, as a result, the edge of the second isolation structure in the partition structure protrudes relative to the edge of the first isolation structure, which enables the second isolation structure in the partition structure to have an obvious protrusion portion, thereby being beneficial to reduce the risk of crosstalk.

The display panel and the manufacturing method thereof, and the display apparatus provided by the embodiments of the present disclosure will be described below in conjunction with the accompanying drawings.

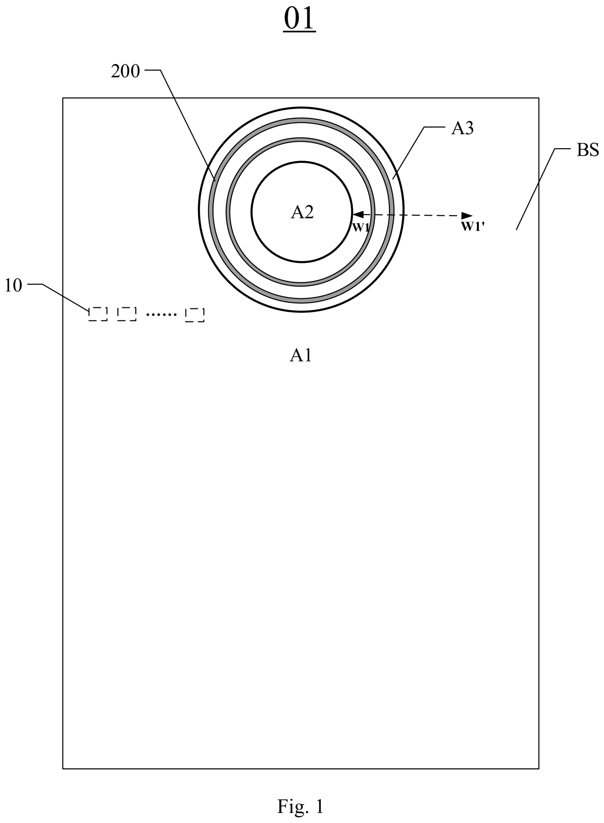

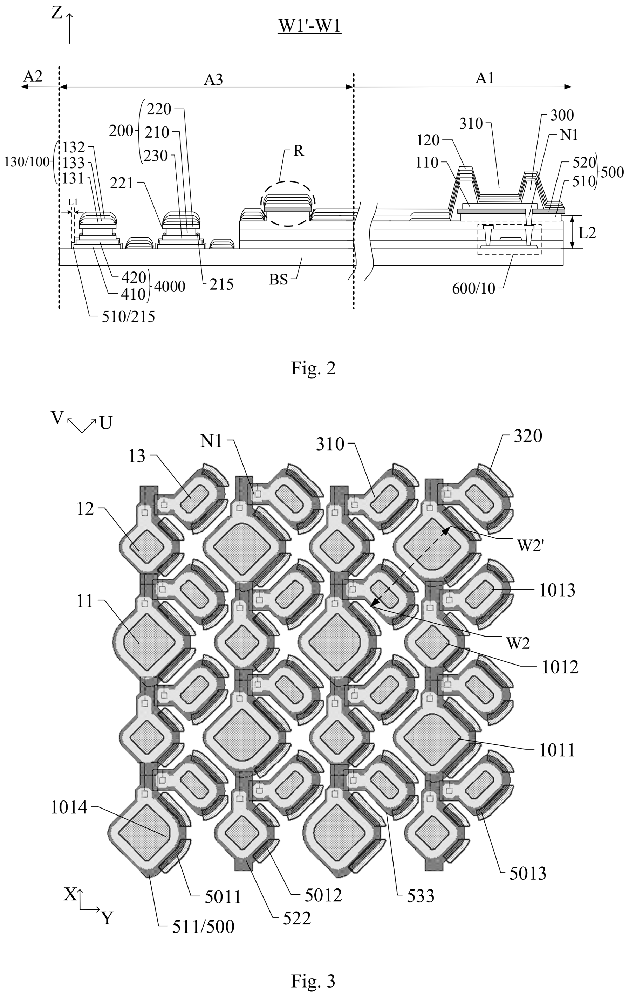

Fig. 1 is a plan view of a display panel provided by at least one embodiment of the present disclosure; Fig. 2 is a partial cross-sectional view taken along a line W1-W1' illustrated in Fig. 1.

As illustrated in Fig. 1, the display panel 01 includes a first region A1, a second region A2 and a third region A3. The first region A1 is a display region and is configured to display. The second region A2 is a hollowed region and is configured to transmit light. For example, a device such as a photosensitive sensor may be arranged in the second region A2. For example, the first region A1 may be located on at least one side of the second region A2. For example, in some embodiments, the first region A1 surrounds the second region A2, that is, the second region A2 may be surrounded by the first region A1. For example, the second region A2 may further be arranged at other positions, which may be specifically determined according to needs. For example, the second region A2 may be located at a top center position of a base substrate BS.

For example, the photosensitive sensor may be, but not limited to, an infrared sensor, an ultrasonic sensor, a light detection and ranging (LIDAR) sensor, a radar sensor, a camera, and a distance sensor. The display panel 01 illustrated in Fig. 1 is described by assuming that the second region A2 is circular and the second region A2 is located at an upper middle portion of the display panel 01, but it is not limited thereto.

As illustrated in Fig. 1, the display panel 01 includes the base substrate BS and a plurality of sub-pixels 10 located on the base substrate BS. The plurality of sub-pixels 10 are located in the first region A1, so that the first region A1 serves as a display region. As illustrated in Fig. 1 and Fig. 2, each of at least some of the sub-pixels 10 includes a light-emitting functional layer 130, and the light-emitting functional layer 130 includes a plurality of film layers. For example, each of the at least some of the sub-pixels 10 includes a light-emitting element 100, and the light-emitting element 100 includes a light-emitting functional layer 130, and a first electrode 110 and a second electrode 120 located on two sides of the light-emitting functional layer 130 in a direction perpendicular to the base substrate BS, the first electrode 110 is located between the light-emitting functional layer 130 and the base substrate BS. For example, each sub-pixel 10 located in the first region A1 includes a light-emitting element 100, for example, the light-emitting element 100 may be an organic light-emitting element.

For example, as illustrated in Fig. 2, the light-emitting functional layer 130 in the light-emitting element 100 may include a first light-emitting layer (EML) 131, a charge generation layer (CGL) 133, and a second light-emitting layer (EML) 132, which are arranged in a layered configuration, and the charge generation layer 133 is located between the first light-emitting layer 131 and the second light-emitting layer 132. The charge generation layer 133 has strong conductivity, which may allow the light-emitting functional layer 130 to have advantages of long lifespan, low power consumption and high brightness. For example, as compared with a light-emitting functional layer 130 without the charge generation layer 133, the brightness of the light-emitting element 100 can be nearly doubled by providing the charge generation layer 133 in the light-emitting functional layer 130. For example, the light-emitting element 100 of the sub-pixel 10 may be a tandem light-emitting element, such as a tandem OLED. For example, the first light-emitting layer 131 and the second light-emitting layer 132 may be structures obtained after patterning, and the charge generation layer 113 may be a structure arranged in a whole layer.

For example, as illustrated in Fig. 2, the charge generation layer 133 may include an N-type charge generation layer and a P-type charge generation layer. For example, in each sub-pixel 10, the light-emitting functional layer 130 may further include a hole injection layer (HIL), a hole transport layer (HTL), an electron transport layer (ETL) and an electron injection layer (EIL). For example, the hole injection layer (HIL), the hole transport layer (HTL), the electron transport layer (ETL), the electron injection layer (EIL) and the charge generation layer 133 are all shared film layers of the plurality of sub-pixels 10, which can be referred to as common layers.

For example, as illustrated in Fig. 2, the second light-emitting layer 132 may be located between the first light-emitting layer 131 and the second electrode 120, and the hole transport layer may be located between the first electrode 110 and the first light-emitting layer 131. For example, the electron transport layer may further be arranged between the charge generation layer 133 and the first light-emitting layer 131. For example, the hole transport layer may be arranged between the second light-emitting layer 132 and the charge generation layer 133. For example, the electron transport layer and the electron injection layer may be arranged between the second light-emitting layer 132 and the second electrode 120.

For example, the material of the electron transport layer may include aromatic heterocyclic compounds, for example, imidazole derivatives such as benzimidazole derivatives, imidazolium pyridine derivatives, benzimidazole phenanthridine derivatives, etc.; zine derivatives such as pyrimidine derivatives, triazine derivatives, etc.; compounds containing nitrogen-containing six-membered ring structures (also including compounds having substitution groups of phosphine oxide series on heterocycles) such as quinoline derivatives, isoquinoline derivatives, phenanthroline derivatives, etc. For example, the charge generation layer 133 may be made from a material containing phosphorus oxide groups or a material containing triazine. For example, a ratio of electron mobility of the material of the charge generation layer 133 to electron mobility of the electron transport layer is 10⁻² to 10².

For example, as illustrated in Fig. 2, the first electrode 110 may be an anode; and the second electrode 120 may be a cathode. For example, the cathode may be made from a material with high conductivity and low power function, and for example, the cathode may be made from a metal material. For example, the anode may be formed of a transparent conductive material with a high work function.

For example, as illustrated in Fig. 2, an orthogonal projection of the second electrodes 130 in at least some sub-pixels 10 on the base substrate BS is a whole-face structure. For example, the second electrode 130 may be a common electrode shared by a plurality of sub-pixels 10. For example, the second electrode 130 may be a common electrode shared by the above-described at least some sub-pixels 10.

For example, as illustrated in Fig. 2, an insulation layer 50 is provided between the first electrode 110 and the base substrate BS. Fig. 2 omits some structures between the insulation layer 50 and the base substrate BS, such as a film layer where signal lines such as data lines are located and other insulation layers.

As illustrated in Fig. 1 and Fig. 2, the display panel 01 further includes at least one partition structure 200 located on the base substrate BS. The partition structure 200 is located in the third region A3, and includes a first isolation structure 210 and a second isolation structure 220 which are arranged in a layered way. The second isolation structure 220 is located on a side of the first isolation structure 210 away from the base substrate BS, and an edge of the second isolation structure 220 protrudes relative to an edge of the first isolation structure 210, the partition structure 200 is configured to isolate at least one film layer of the light-emitting functional layer 130.

For example, as illustrated in Fig. 1 and Fig. 2, at least one film layer in the light-emitting functional layer 130 may be disconnected at an edge of the partition structure 200, for example, at least one film layer in the light-emitting functional layer 130 partitioned by the partition structure 200 may be at least one film layer among the above-mentioned common layers. By partitioning at least one film layer among the above-mentioned common layers at the edge of the partition structure 200, it is beneficial to reduce a risk of crosstalk in the third region A3, and allow the sub-pixels 10 in the first region A1 to have a good light-emitting state.

As illustrated in Fig. 1 and Fig. 2, the display panel further includes an insulation layer 215 located on the base substrate BS, and at least a portion of the insulation layer 215 is located on a side wall of each of the at least one partition structure 200 in the third region A3. For example, the insulation layer 215 may be a residual structure remaining on the side wall of the partition structure 200 during a formation of the partition structure 200. For example, in the process of forming the partition structure 200, an outer surface of an initial partition structure used to form the partition structure 200 is covered with a "protective film layer", which is then removed after other film layers are patterned. The initial partition structure is patterned to form the partition structure 200, and make the partition structure 200 have an "undercut" structure. For example, the "protective film layer" may be, but not limited to, an insulation film layer. For example, the insulation layer 215 may include, but not limited to, a residual film layer that has not been completely removed from the "protective film layer". For example, the "protective film layer" is completely removed, and the insulation layer 215 may include some film layers formed on the "protective film layer" and not completely removed during the patterning process.

For example, the "protective film layer" may provide preliminary protection for the formation of the partition structure 200, so that the partition structure 200 can be formed separately after the patterning of other structures, thereby reducing the influence of other film layers on the partition structure 200, for example, preventing other film layers from filling the "undercut" structure of the partition structure 200, which makes it difficult for the partition structure 200 to perform the function of partition. **In** view of a precision of the manufacturing process, it is difficult to completely remove the insulation layer 215 on the side wall of the finally formed partition structure 200, so at least a portion of the insulation layer 215 will remain on the side wall of the partition structure 200.

The partition structure 200 provided by the embodiment of the present disclosure is simple in structure, and its manufacturing process is easy to control. The portion intended to partition within the partition structure 200 is not covered or filled by other film layers. The edge of the second isolation structure 220 in the partition structure 200 protrudes relative to the edge of the first isolation structure 210, which enables the second isolation structure 220 in the partition structure 200 to have an obvious protrusion portion, thereby being beneficial to reduce the risk of crosstalk.

For example, as illustrated in Fig. 2, the second isolation structure 220 includes a protrusion portion 221 which protrudes relative to the edge of the first isolation structure 210, so that the second isolation structure 220 can have an "undercut" structure, so as to partition at least one film layer in the light-emitting functional layer 130. For example, at least a portion of the insulation layer 215 located on the side wall of the partition structure 200 and the protrusion portion 221 of the partition structure 200 are spaced apart from each other in the direction perpendicular to the base substrate BS. For example, a certain distance exists between the insulation layer 215 located on the side wall of the partition structure 200 and the protrusion portion 221 in the direction perpendicular to the base substrate BS, so this portion of the insulation layer 215 will not affect the partition function of the partition structure 200.

For example, as illustrated in Fig. 2, the direction perpendicular to the base substrate BS is a Z direction. For example, at least a portion of the insulation layer 215 may be located on the side wall of the first isolation structure 210. For example, a size of the portion, on the side wall of the first isolation structure 210, of the insulation layer 215 in the Z direction may be 1/10 to 1/3 of a size of the first isolation structure 210 in the Z direction, for example, it may be at least one of 1/5 to 1/3, 1/6 to 1/4, 1/7 to 1/5, 1/8 to 1/6 and 1/9 to 1/7, which is not limited by the embodiment of the present disclosure.

For example, as illustrated in Fig. 2, the partition structure 200 may further include a third isolation structure 230. The first isolation structure 210, the second isolation structure 220 and the third isolation structure 230 are arranged in a layered configuration, and the third isolation structure 230 is located at a side, close to the base substrate BS, of the first isolation structure 210. For example, the third isolation structure 230 may also have a protrusion portion protruding relative to the edge of the first isolation structure 210, so that the partition structure 200 has an "I"-shaped structure. For example, at least a portion of the insulation layer 215 may also be located on a side wall of the third isolation structure 230, thereby creating a large distance between the insulation layer 215 and the protrusion portion 221 of the second isolation structure 220 in the Z direction, which is beneficial for the partition structure 200 to partition at least one film layer in the light-emitting functional layer 130.

For example, as illustrated in Fig. 2, the first isolation structure 210, the second isolation structure 220 and the third isolation structure 230 all include metal materials. For example, the material of the first isolation structure 210 is different from that of the second isolation structure 220, and the material of the second isolation structure 220 is the same as that of the third isolation structure 230. For example, the partition structure 200 may include a titanium/aluminum/titanium structure, which is not limited by the embodiments of the present disclosure. For example, in some embodiments, the material of the first isolation structure 210, the material of the second isolation structure 220 and the material of the third isolation structure 230 may be different, which is not limited by the embodiments of the present disclosure.

For example, as illustrated in Fig. 2, the display panel 01 further includes a pixel defining pattern 300, which is located in the first region A1 and on the base substrate BS, and the pixel defining pattern 300 includes a plurality of first openings 310 to define light-emitting regions of at least some of the sub-pixels 10. For example, one sub-pixel 10 corresponds to at least one first opening 310, at least a portion of the light-emitting element 100 of the sub-pixel 10 is located in the corresponding first opening 310, and the first opening 310 is configured to expose the first electrode 110 of the sub-pixel 10. For example, the first opening 310 exposes a portion of the first electrode 110. For example, one sub-pixel 10 may correspond to one first opening 310.

For example, as illustrated in Fig. 2, in response to the light-emitting functional layer 130 being formed in the first opening 310 of the pixel defining pattern 400, the first electrode 110 and the second electrode 120 at two sides of the light-emitting functional layer 130 may drive the light-emitting functional layer 130 in the first opening 310 to emit light. For example, the light-emitting region may refer to a region of the sub-pixel that effectively emits light, and the shape of the light-emitting region refers to a two-dimensional shape, for example, the shape of the light-emitting region may be the same as the shape of the first opening 310 of the pixel defining pattern 400.

For example, as illustrated in Fig. 2, the display panel 01 further includes a defining structure 500, which is located in the first region A1 and between the light-emitting functional layer 130 and the base substrate BS, and the defining structure 500 includes a portion surrounding the light-emitting region of each of at least some sub-pixels 10. For example, the defining structure 500 is located between the first electrode 110 and the base substrate BS, and an orthographic projection of the first opening 310 on the base substrate BS falls within an orthographic projection of the defining structure 500 on the base substrate BS. For example, an orthographic projection of the first electrode 110 on the base substrate BS falls within the orthographic projection of the defining structure 500 on the base substrate BS.

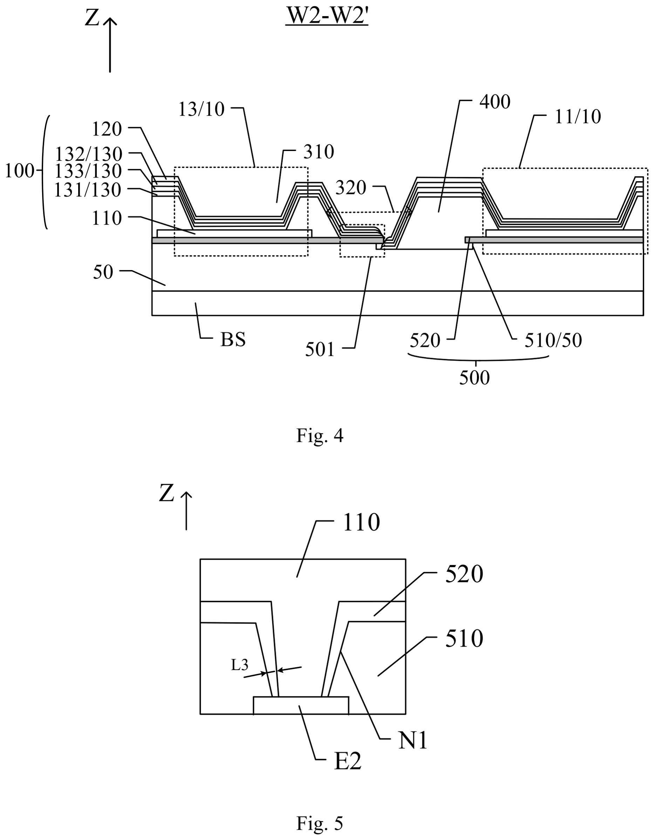

Fig. 3 is a schematic diagram of a first region of a display panel illustrated in Fig. 1 in an example. Fig. 4 is a partial cross-sectional view taken along a line W2-W2' illustrated in Fig. 3.

For example, as illustrated in Fig. 2 and Fig. 3, the pixel defining pattern 300 further includes a second opening 320. A portion, located in the first opening 310, of at least one film layer in the light-emitting functional layer 130 is a continuous portion, a portion, located in at least one second opening 320, of at least one film layer in the light-emitting functional layer 130 is at least partially partitioned, and a portion, exposed by the second openings 320, of the defining structure 500 is configured to partition at least one film layer of the light-emitting functional layer 130. For example, in some embodiments of the present disclosure, the first light-emitting layer 131 and the second light-emitting layer 132 may not be arranged in the third region A3, so that the partition structure 200 may be used to partition at least one film layer of the light-emitting functional layer 130, excluding the first light-emitting layer 131 and the second light-emitting layer 132.

For example, as illustrated in Fig. 4, the portion, exposed by the second opening 320, of the defining structure 500 include a defining partition portion 501, the defining partition portion 501 is arranged between at least two adjacent sub-pixels 10, and at least one film layer in the light-emitting functional layer 130 is disconnected at an edge of the defining partition portion 501. By arranging the defining partition portion 501 between adjacent sub-pixels 10 to partition at least one film layer in the light-emitting functional layer 130, a probability of crosstalk between adjacent sub-pixels 10 may be reduced. For example, the defining partition portion 501 refer to a structure exposed by the second opening 320 in the defining structure 500.

"Adjacent sub-pixels" in any embodiment of the present disclosure means that no other sub-pixels are arranged between two sub-pixels. The adjacent sub-pixels may be two sub-pixels of the same color or two sub-pixels of different colors.

For example, as illustrated in Fig. 4, at least a portion of the second electrode 120 is disconnected at the edge of the defining partition portion 501.

For example, as illustrated in Fig. 4, the defining structure 500 includes a first sub-defining structure 510 and a second sub-defining structure 520, which are arranged in a layered way. The first sub-defining structure 510 is located at a side, close to the base substrate BS, of the second sub-defining structure 520, and an edge of the second sub-defining structure 520 protrudes relative to an edge of the first sub-defining structure 510, so as to partition at least one film layer of the light-emitting functional layer 130, thereby reducing the risk of crosstalk between adjacent sub-pixels.

For example, as illustrated in Fig. 2, the insulation layer 215 may include a portion located in the first region A1, and the portion may include at least one of the first sub-defining structure 510 and the second sub-defining structure 520. For example, an initial partition structure used to form the partition structure 200 is formed before the defining structure 500 is formed, and the partition structure 200 with the "undercut" structure may be formed after the initial partition structure is patterned. For example, in a process of forming the defining structure 500, a film layer for forming the first sub-defining structure 510 and a film layer for forming the second sub-defining structure 520 are provided in the first region A1 and the third region A3, and then patterning is performed, so that the first sub-defining structure 510 and the second sub-defining structure 520 can be obtained to form the defining structure 500. In this process, a portion, located in the third region A3, of the film layer used to form the first sub-defining structure 510 and a portion, located in the third region A3, of the film layer used to form the second sub-defining structure 520 are largely removed, leaving only a small portion remaining on the side wall of the partition structure 200. Subsequently, the partition structure 200 can be obtained by patterning the initial partition structure. With this arrangement, the risk of other film layers filling the "undercut" structure of the partition structure 200 can be reduced without adding additional process flow, which is beneficial for the partition structure 200 to perform the function of partition.

For example, as illustrated in Fig. 2, the insulation layer 215 may be a residual structure, not completely removed during the patterning process, of the portion of the film layer used to form the first sub-defining structure 510 located in the third region A3. Any one of the first sub-defining structure 510 and the second sub-defining structure 520 may be included. For example, in the case of the first sub-defining structure 510, the insulation layer 215 may be a residual structure, not completely removed during the patterning process, of the portion of the film layer used to form the first sub-defining structure 510 located in the third region A3. For example, the portion, located in the third region A3, of the film layer used to form the first sub-defining structure 510 covers a surface of the initial partition structure, and then is largely removed after (or at the same time with) the patterning treatment of other film layers, so that the partition structure 200 with an "undercut" structure can be formed through patterning treatment of the initial partition structure. Thus, the portion, located in the third region A3, of the film layer used to form the first sub-defining structure 510 covering the surface of the initial partition structure may reduce the risk of other film layers filling the "undercut" structure of the partition structure 200.

For example, as illustrated in Fig. 2, the material of the first sub-defining structure 510 is different from that of the second sub-defining structure 520. For example, the material of the first sub-defining structure 510 may include an organic material or an inorganic non-metallic material, and the material of the second sub-defining structure 520 may include an inorganic non-metallic material or a metallic material. For example, the material of the first sub-defining structure 510 may include silicon nitride or silicon oxide. For example, the material of the second sub-defining structure 520 may include polyimide or other materials.

For example, as illustrated in Fig. 2, for the same etching solution, an etching selectivity of the first isolation structure 210, an etching selectivity of the first sub-defining structure 510 and an etching selectivity of the second sub-defining structure 520 decrease in sequence. For example, for the same etching solution, the etching selectivity of the first sub-defining structure 510 is greater than that of the second sub-defining structure 520, which allows the edge of the first sub-defining structure 510 obtained after etching to retract inward relative to the edge of the second sub-defining structure 520, so that the defining structure 500 has partition capability. For example, for the same etching solution, the etching selectivity of the first isolation structure 210 is greater than that of the first sub-defining structure 510, so that at least a portion of the first isolation structure 210 can be etched while the first sub-defining structure 510 is formed, which allows the edge of the first isolation structure 210 to retract inward relative to the edge of the second isolation structure 220, thus facilitating the formation of the "undercut" structure of the partition structure 200.

For example, as illustrated in Fig. 2, in order to improve the exposure capability, the display panel 01 further includes at least one layer of metal structure 4000 located between the partition structure 200 and the base substrate BS. In the third region A3, an orthographic projection of the partition structure 200 on the base substrate BS falls within an orthographic projection of the at least one layer of metal structure 4000 on the base substrate BS. For example, the arrangement of the at least one layer of metal structure 4000 may make the partition structure 200 farther away from the base substrate BS in the Z direction, which is beneficial to improving an exposure effect in the process of forming the partition structure 200, and enabling the partition structure 200 to have an "undercut" structure that meets requirements.

For example, as illustrated in Fig. 2, the at least one layer of metal structure 4000 includes a first metal structure 410 and a second metal structure 420. In the third region A3, the first metal structure 410, the second metal structure 420 and the partition structure 200 are sequentially arranged in a layered way in the direction perpendicular to the base substrate BS, and the partition structure 200 is located at a side, away from the base substrate BS, of the second metal structure 420. For example, the first metal structure 410 and the second metal structure 420 may adopt different metal materials, and the first metal structure 410 is located at a side, close to the base substrate BS, of the second metal structure 420. For example, the first metal structure 410 and the second metal structure 420 may make the partition structure 200 and the base substrate BS spaced apart from each other, and make the partition structure 200 "raised", thus improving the exposure effect in the process of forming the partition structure 200.

For example, as illustrated in Fig. 2, the orthographic projection of the partition structure 200 on the base substrate BS falls within an orthographic projection of the second metal structure 420 on the base substrate BS. This arrangement makes the partition structure 200 more stable and reduces the risk of offset or dislocation of the partition structure 200. For example, an edge of the partition structure 200 has a certain retraction size relative to an edge of the second metal structure 420, for example, the retraction size may be 0.05 to 0.5µm, such as at least one selected from the group consisting of 0.05 to 0.1µm, 0.15 to 0.2µm, 0.25 to 0.3µm, 0.35 to 0.4µm and 0.45 to 0.5µm, which is not limited by the embodiments of the present disclosure.

For example, as illustrated in Fig. 2, the edge of the second metal structure 420 may also have a certain retraction size relative to an edge of the first metal structure 410, so that the second metal structure 420 can be firmly arranged on the first metal structure 410, thus improving the stability of the partition structure 200 and reducing the risk of offset or dislocation of the partition structure 200. For example, in some embodiments of the present disclosure, the edge of the second metal structure 420 may be flush with the edge of the first metal structure 410 in the Z direction.

For example, as illustrated in Fig. 2, a portion, located in the first region A1, of the insulation layer 215 includes the first sub-defining structure 510, and at least a portion of the insulation layer 215 covers an outer wall of the first metal structure 410 and an outer wall of the second metal structure 420. For example, the portion, located in the first region A1, of the insulation layer 215 may include the first sub-defining structure 510 only. For example, the initial partition structure used to form the partition structure 200 is formed before the defining structure 500 is formed, and the partition structure 200 with the "undercut" structure may be formed after the initial partition structure is patterned. For example, in the process of forming the defining structure 500, a film layer for forming the first sub-defining structure 510 and a film layer for forming the second sub-defining structure 520 are provided in the first region A1 and the third region A3, and then patterning is performed, so that the first sub-defining structure 510 and the second sub-defining structure 520 can be obtained to form the defining structure 500. In this process, the portion, located in the third region A3, of the film layer used to form the second sub-defining structure 520 is largely removed, and the portion, located in the third region A3, of the film layer used to form the first sub-defining structure 510 is not completely removed, but instead, the portion covering the outer wall of the first metal structure 410 and the outer wall of the second metal structure 420 is retained, so that the light-emitting functional layer 130 is separated from the first metal structure 410 and the second metal structure 420, reducing the risk of crosstalk.

For example, as illustrated in Fig. 2, an average thickness of the portion, covering the outer wall of the first metal structure 410 and the outer wall of the second metal structure 420, of the insulation layer 215 is a first thickness L1, an average thickness of the first sub-defining structure 510 located in the first region A1 in the insulation layer 215 is a second thickness L2, and the first thickness L1 is smaller than the second thickness L2. For example, a thickness of a portion, covering the outer wall of the first metal structure 410, of the insulation layer 215 and a thickness of a portion, covering the outer wall of the second metal structure 420, of the insulation layer 215 are approximately equal, and both are smaller than the average thickness L2 of the portion, located in the first region A1, of the insulation layer 215 (for example, the first sub-defining structure 510). By making the first thickness L1 of the portion, covering the outer wall of the first metal structure 410 and the outer wall of the second metal structure 420, of the insulation layer 215 small, a distance between adjacent partition structures 200 in the third region A3 is reduced while keeping the first metal structure 410 and the second metal structure 420 apart from the light-emitting functional layer 130, so as to save the layout space of the third region A3.

For example, as illustrated in Fig. 2, the first thickness L1 is 1/100 to 1/10 of the second thickness L2, such as at least one of 1/100 to 1/50, 1/80 to 1/40, 1/70 to 1/60, 1/40 to 1/20, 1/15 to 1/10, 1/12 to 1/10 and 1/10 to 1/5, which is not limited by the embodiments of the present disclosure.

For example, as illustrated in Fig. 1 and Fig. 2, the display panel 01 includes a plurality of partition structures 200 arranged at intervals, and the partition structure 200 has a shape of a ring and surrounds the second region A2. For example, the partition structure 200 may include a ring-shaped structure surrounding the second region A2. For example, the orthogonal projection of the partition structure 200 on the base substrate BS may be, but not limited to, in a closed ring shape. For example, the number of the partition structures 200 in the third region A3 may be 2 to 8, such as at least one of 2 to 5, 3 to 6, 4 to 7, 5 to 6 and 7 to 8, which is not limited by the embodiments of the present disclosure.

For example, as illustrated in Fig. 2, at least a portion of the base substrate BS between adjacent partition structures 200 does not overlap with the insulation layer 215. For example, in the process of manufacturing the display panel 01, the portion of the insulation layer 215 between adjacent partition structures 200 is removed to facilitate the formation of the partition structures 200. For example, in some embodiments, a portion, located between the edge of the first region A1 close to the third region A3 and the partition structure 200 adjacent to the edge, of the base substrate BS also does not overlap with the insulation layer 215.

For example, as illustrated in Fig. 2, the display panel further includes a pixel circuit 600. The pixel circuit 600 is located at a side, close to the base substrate BS, of the first sub-defining structure 510, and is electrically connected with the first electrode 110. For example, the pixel circuit 600 is configured to drive the light-emitting elements 100 to emit light. For example, the pixel circuit 600 is configured to provide driving current to drive the light-emitting elements 100 to emit light. For example, the pixel circuit may include a plurality of transistors and at least one capacitor (not illustrated in the figure), and the first electrode 110 may be electrically connected with the pixel circuit 600 through a connection via hole N1.

Fig. 5 is a partial enlarged view of a connection via hole N1 in Fig. 2.

For example, as illustrated in Fig. 2, Fig. 3 and Fig. 5, a film layer where the first sub-defining structure 510 is located includes a connection via hole N1, the pixel circuit 600 is electrically connected with the first electrode 110 through the connection via hole N1, and at least a portion of the second sub-defining structure 520 extends into the connection via hole N1 and covers a side wall of the connection via hole N1.

For example, as illustrated in Fig. 2, Fig. 3 and Fig. 5, in response to at least a portion of the second sub-defining structure 520 extending into the connection via hole N1, a portion, close to an opening edge of the connection via hole N1, of the first sub-defining structure 510 is covered by the second sub-defining structure 520, so that it is difficult to etch the portion, close to the opening edge of the connection via hole N1, of the first sub-defining structure 510 in the process of forming the second sub-defining structure 520, thereby reducing a loss of this portion of the first sub-defining structure 510, and further reducing a risk of the first electrode 110 breaking close to the opening of the connection via hole N1 and minimizing the risk of display panel issues such as mura or pixel dark spots.

For example, as illustrated in Fig. 2, Fig. 3 and Fig. 5, in response to at least a portion of the second sub-defining structure 520 extending into the connection via hole N1, this portion of the second sub-defining structure 520 may only cover a portion of the side wall of the connection via hole N1. For example, at least a portion of the second sub-defining structure 520 may cover only a portion close to the opening of the connection via hole N1. For example, in response to at least a portion of the second sub-defining structure 520 extending into the connection via hole N1 and completely covers the side wall of the connection via hole N1, the first sub-defining structure 510 will not have any loss in the process of forming the second sub-defining structure 520.

For example, as illustrated in Fig. 2, Fig. 3 and Fig. 5, a thickness L3 of the portion, extending into the connection via hole N1 and covering the side wall of the connection via hole N1, of the second sub-defining structure 520 is greater than 1µm, such as at least one of 1 to 1.2µm, 1.3 to 1.5µm, 1.4 to 1.6µm, 1.6 to 1.8µm and 1.7 to 2µm, which is not limited by the embodiments of the present disclosure.

For example, as illustrated in Fig. 2, a partition structure R are also provided in the third region A3, and the partition structure R is also configured to partition at least one layer in the light-emitting functional layer 130. For example, an orthogonal projection of the partition structure R on the base substrate BS may have a shape of closed-ring. For example, the number of the partition structures R may be 1 to 5, such as at least one of 2 to 4, 3 to 5 and 1 to 2, which is not limited by the embodiments of the present disclosure.

For example, as illustrated in Fig. 3, the display panel includes a first sub-pixel 11, a second sub-pixel 12, and a third sub-pixel 13. For example, the first sub-pixel 11, the second sub-pixel 12 and the third sub-pixel 13 are configured to emit light of different colors, but it is not limited thereto. For example, any two of the first sub-pixel 11, the second sub-pixel 12, and the third sub-pixel 13 may be configured to emit light of the same color. For example, an area of a light-emitting region of one first sub-pixel 11 is larger than that of one second sub-pixel 12, and the area of the light-emitting region of one first sub-pixel 11 is larger than that of one third sub-pixel 13. For example, the area of the light-emitting region of one second sub-pixel 12 is larger than that of one third sub-pixel 13.

In some examples, as illustrated in Fig. 3, the first sub-pixel 11 is a blue sub-pixel, one of the second sub-pixel 12 and the third sub-pixel 13 is a red sub-pixel, and the other of the second sub-pixel 12 and the third sub-pixel 13 is a green sub-pixel. Fig. 3 schematically shows that the second sub-pixel 12 is a red sub-pixel and the third sub-pixel 13 is a green sub-pixel, but it is not limited thereto. For example, the second sub-pixel 12 may be a green sub-pixel and the third sub-pixel 13 may be a red sub-pixel.

For example, as illustrated in Fig. 3, in the direction perpendicular to the base substrate BS, the defining structure 500 includes a portion overlapping with the pixel defining pattern 300, a portion overlapping with the first openings 310, and a portion overlapping with the second openings 320. A portion, exposed by the second opening 320, of the defining structure 500 is configured to partition at least one film layer of the light-emitting functional layer 130. For example, the defining structure 500 includes a first defining structure 511, a second defining structure 522, and a third defining structure 533. For example, the first defining structure 511 includes a portion overlapping with the light-emitting region of the first sub-pixel 11 and a portion surrounding the light-emitting region of the first sub-pixel 11, the second defining structure 522 includes a portion overlapping with the light-emitting region of the second sub-pixel 12 and a portion surrounding the light-emitting region of the second sub-pixel 12, and the third defining structure 533 includes a portion overlapping with the light-emitting region of the third sub-pixel 13 and a portion surrounding the light-emitting region of the third sub-pixel 13.

For example, as illustrated in Fig. 3 and Fig. 4, a portion, exposed by the second opening 320, of the first defining structure 511 is a first defining partition portion 5011, a portion, exposed by the second opening 320, of the second defining structure 522 is a second defining partition portion 5012, and a portion, exposed by the second opening 320, of the third defining structure 533 is a third defining partition portion 5013. The light-emitting functional layer 130 and the second electrode 120 of the first sub-pixel 11 are disconnected at an edge of the first defining partition portion 5011. The light-emitting functional layer 130 and the second electrode 120 of the second sub-pixel 12 are disconnected at an edge of the second defining partition portion 5012. The light-emitting functional layer 130 and the second electrode 120 of the third sub-pixel 13 are disconnected at an edge of the third defining partition portion 5013.

For example, as illustrated in Fig. 3, only one defining structure is provided between two adjacent sub-pixels arranged in a U direction, and only one defining structure is provided between two adjacent sub-pixels arranged in a V direction, so as to balance the crosstalk and power consumption between adjacent sub-pixels.

For example, as illustrated in Fig. 3, the portions, exposed by the second openings 320, of the defining structures corresponding to the first sub-pixel 11, the second sub-pixel 12, and the third sub-pixel 13 are all discontinuous structures. Orthographic projections of the first defining partition portion 5011, the second defining partition portion 5012 and the third defining partition portion 5013 on the base substrate all have a shape of non-closed ring.

For example, as illustrated in Fig. 3, the first sub-pixel 11 includes a first corner portion 1011 formed by connecting two adjacent sides of its light-emitting region, and at least one first defining partition portion 5011 only surrounds the portion of the two adjacent sides of the light-emitting region of the first sub-pixel 11 except the first corner portion 1011. The second sub-pixel 12 includes a second corner portion 1012 formed by connecting two adjacent sides of its light-emitting region, and at least one second defining partition portion 5012 only surrounds the portion of the two adjacent sides of the light-emitting region of the second sub-pixel 12 except the second corner portion 1012. The third sub-pixel 13 includes a third corner portion 1013 formed by connecting two adjacent sides of its light-emitting region, and at least one third defining partition portion 5013 only surrounds the portion of the two adjacent sides of the light-emitting region of the third sub-pixel 13 except the third corner portion 1013. The first corner portion 1011, the second corner portion 1012 and the third corner portion 1013 have the same orientation.

For example, as illustrated in Fig. 3, each side of the light-emitting region of the first sub-pixel 11 or their extension lines are connected to form a polygon, and a plurality of vertices of the polygon have regions that do not overlap with a plurality of corresponding corner portions of the light-emitting region. The light-emitting region of the first sub-pixel 11 includes at least one specific corner portion 1014, and an area where the specific corner portion 1014 and the corresponding vertex of the polygon do not overlap is larger than an area where each of at least some other corner portions does not overlap the corresponding vertex of the polygon.

Fig. 3 schematically shows that the first corner portion 1011, the second corner portion 1012 and the third corner portion 1013 all face a right side, such as a Y direction, but it is not limited thereto. For example, the first corner portion 1011, the second corner portion 1012 and the third corner portion 1013 may all face a left side (such as a direction opposite to the Y direction as indicated by the arrow); or face a lower side, such as a opposite direction of the arrow in the X direction.

For example, as illustrated in Fig. 3, the defining structures at corresponding positions of the first corner portion 1011, the second corner portion 1012 and the third corner portion 1013 are not exposed by the second openings 320, so as to improve the continuity of the second electrode 120 and reduce the power consumption of the display panel.

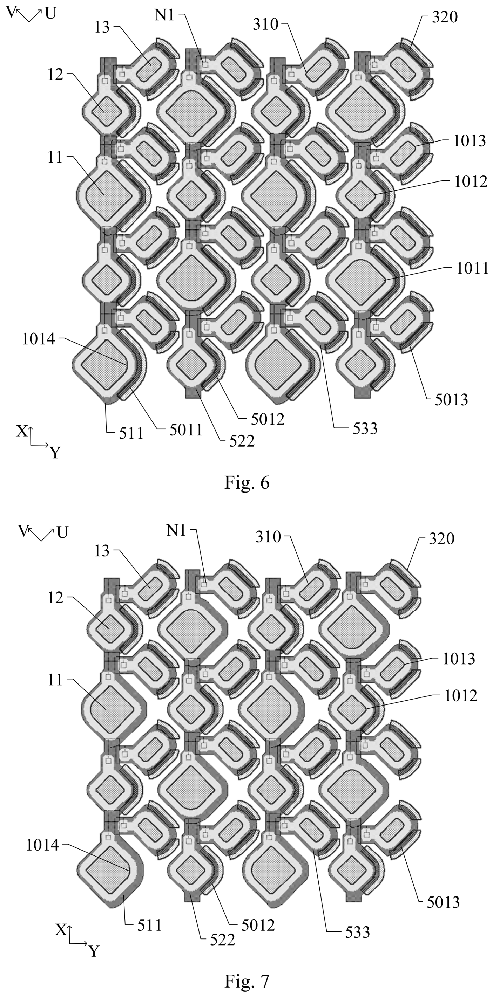

Fig. 6 is a structural diagram of a first region of a display panel illustrated in Fig. 1 in another example.

For example, the display panel illustrated in Fig. 6 is different from the display panel illustrated in Fig. 3 in that the portion, exposed by the second opening 320, of the first defining structure 511 (that is, the first defining partition portion 5011) has a different shape, and the portion, exposed by the second opening 320, of the second defining structure 522 (that is, the second defining partition portion 5012) has a different shape. For remaining structural features, please refer to the related description about Fig. 3 in the above embodiment, which will not be repeated here.

For example, as illustrated in Fig. 6, the portion, exposed by the second opening 320, of the first defining structure 511 corresponding to the first sub-pixel 11 is a continuous structure, the portion, exposed by the second opening 320, of the second defining structure 522 corresponding to the second sub-pixel 12 is a continuous structure, and the portion, exposed by the second openings 320, of the third defining structure 533 corresponding to the third sub-pixel 13 is a discontinuous structure.

For example, as illustrated in Fig. 6, the first sub-pixel 11 includes a first corner portion 1011 formed by connecting two adjacent sides of its light-emitting region, and at least one first defining partition portion 5011 surrounds the two adjacent sides of the light-emitting region of the first sub-pixel 11. The second sub-pixel 12 includes a second corner portion 1012 formed by connecting two adjacent sides of its light-emitting region, and at least one second defining partition portion 5012 surrounds the two adjacent sides of the light-emitting region of the second sub-pixel 12. The third sub-pixel 13 includes a third corner portion 1013 formed by connecting two adjacent sides of its light-emitting region, and at least one third defining partition portion 5013 only surrounds a portion of the two adjacent sides of the light-emitting region of the third sub-pixel 13 except the third corner portion 1013. The first corner portion 1011, the second corner portion 1012 and the third corner portion 1013 have the same orientation.

By not providing the second opening 320 to the third defining partition portion 5013 at the position of the third corner portion 1013, at least one film layer of the light-emitting functional layer of the adjacent sub-pixel is partitioned, and the continuity of the second electrode of the third sub-pixel 13 is improved, so that the power consumption can be reduced.

Fig. 7 is a structural diagram of a first region of a display panel illustrated in Fig. 1 in still another example.

For example, the display panel illustrated in Fig. 7 is different from the display panel illustrated in Fig. 3 in that the first defining structure 511 is not exposed by the second openings 320, and the portion, exposed by the second opening 320, of the second defining structure 522 (that is, the second defining partition portion 5012) has a different shape.

For example, as illustrated in Fig. 7, the first defining structure 511 corresponding to the first sub-pixel 11 is not exposed by the second opening 320, the portion, exposed by the second opening 320, of the second defining structure 522 corresponding to the second sub-pixel 12 is a continuous structure, and the portion, exposed by the second openings 320, of the third defining structure 533 corresponding to the third sub-pixel 13 is a discontinuous structure.

For example, as illustrated in Fig. 7, the second sub-pixel 12 includes a second corner portion 1012 formed by connecting two adjacent sides of its light-emitting region, and at least one second defining partition portion 5012 surrounds the two adjacent sides of the light-emitting region of the second sub-pixel 12. The third sub-pixel 13 includes a third corner portion 1013 formed by connecting two adjacent sides of its light-emitting region, and at least one third defining partition portion 5013 only surrounds the portion of the two adjacent sides of the light-emitting region of the third sub-pixel 13 except the third corner portion 1013. The second corner portion 1012 and the third corner portion 1013 have the same orientation.

For example, as illustrated in Fig. 7, because the area of the light-emitting region of the first sub-pixel 11 is large, the second electrode of the first sub-pixel 11 can have good continuity by making the first defining structure 511 corresponding to the first sub-pixel 11 not exposed by the second opening 320, so as to effectively reduce power consumption.

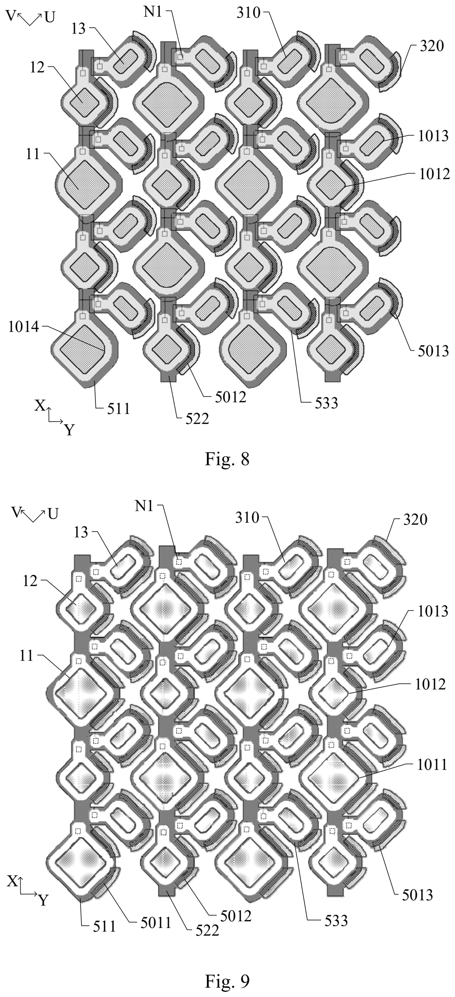

Fig. 8 is a structural diagram of a first region of a display panel illustrated in Fig. 1 in still another example.

For example, the display panel illustrated in Fig. 8 is different from the display panel illustrated in Fig. 7 in that the portion, exposed by the second opening 320, of the third defining structure 533 (that is, the third defining partition portion 5013) has a different shape.

For example, as illustrated in Fig. 8, the first defining structure 511 corresponding to the first sub-pixel 11 is not exposed by the second opening 320, the portion, exposed by the second opening 320, of the second defining structure 522 corresponding to the second sub-pixel 12 is a continuous structure, and the portion, exposed by the second opening 320, of the third defining structure 533 corresponding to the third sub-pixel 13 is a continuous structure.

For example, as illustrated in Fig. 8, the second sub-pixel 12 includes a second corner portion 1012 formed by connecting two adjacent sides of its light-emitting region, and at least one second defining partition portion 5012 surrounds the two adjacent sides of the light-emitting region of the second sub-pixel 12. The third sub-pixel 13 includes a third corner portion 1013 formed by connecting two adjacent sides of its light-emitting region, and at least one third defining partition portion 5013 surrounds the two adjacent sides of the light-emitting region of the third sub-pixel 13. The second corner portion 1012 and the third corner portion 1013 have the same orientation.

For example, as illustrated in Fig. 8, one defining structure is arranged between the first sub-pixel 11 and the second sub-pixel 12, one defining structure is arranged between the second sub-pixel 12 and the third sub-pixel 13, and there is basically no defining structure between the first sub-pixel 11 and the third sub-pixel 13. Therefore, the probability of crosstalk between the first sub-pixel 11 and the second sub-pixel 12 is reduced, and the probability of crosstalk between the second sub-pixel 12 and the third sub-pixel 13 is reduced. Further, because the area of the light-emitting region of the first sub-pixel 11 is large, the second electrode of the first sub-pixel 11 can have good continuity by making the first defining structure 511 corresponding to the first sub-pixel 11 not exposed by the second openings 320, so as to effectively reduce power consumption.

For example, compared with the display panels illustrated in Fig. 3 to Fig. 7, a ratio of an edge length of the third defining structure 533 exposed by the second opening 320 in the display panel illustrated in Fig. 8 to a circumference of the first opening 310 corresponding to the third sub-pixel 13 is smaller, for example, the ratio may be at least one of 10% to 20%, 10% to 15%, 11% to 13%, 12% to 14%, 15% to 16%, 17% to 19% and 18% to 20%, which is not limited by the embodiments of the present disclosure. With this arrangement, the second electrode between the adjacent first sub-pixel 11 and third sub-pixel 13 can have good continuity.

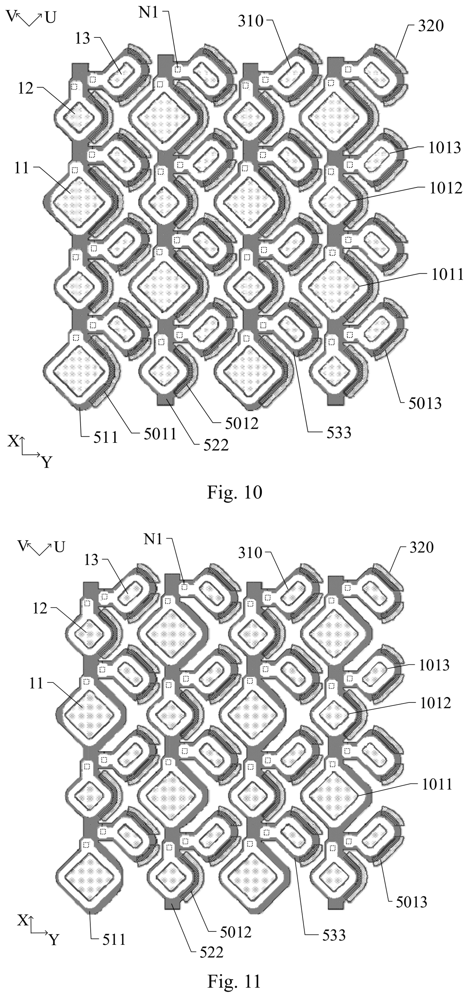

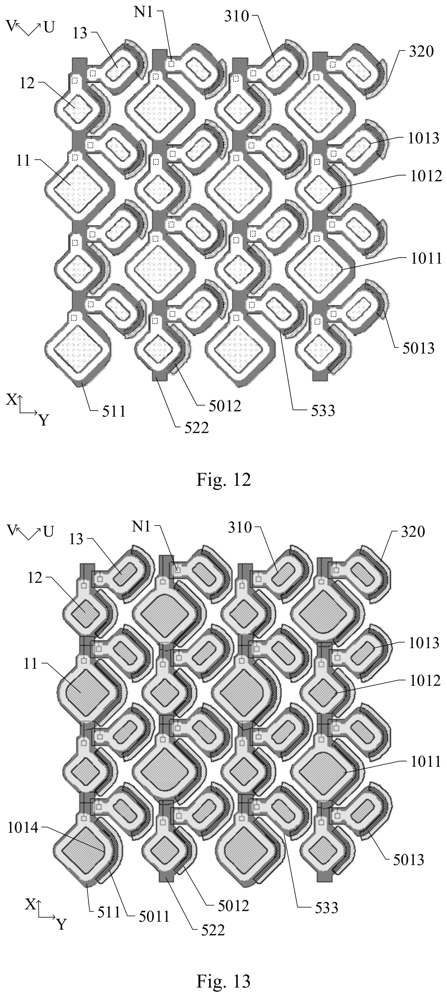

Fig. 9 is a schematic diagram of a first region of a display panel illustrated in Fig. 1 in still another example. Fig. 10 is a schematic diagram of a first region of a display panel illustrated in Fig. 1 in still another example. Fig. 11 is a schematic diagram of a first region of a display panel illustrated in Fig. 1 in still another example. Fig. 12 is a schematic diagram of a first region of a display panel illustrated in Fig. 1 in still another example.

For example, the display panel illustrated in Fig. 9 is different from the display panel illustrated in FIG. 3 in the shape of the light emitting region of the first sub-pixel 11. As shown in FIG. 9, the light emitting region of the first sub-pixel 11 includes four corners which have the same features, that is, the light emitting region of the first sub-pixel 11 shown in FIG. 9 does not include the specific corner 1014 shown in FIG. 3. For the display panel shown in FIG. 9, except that the shape of the light emitting region of the first sub-pixel is different from that of the first sub-pixel shown in FIG. 3, other features are the same as those of the display panel shown in FIG. 3, which will not be repeated here.

For example, the display panel shown in FIG. 10 is different from the display panel shown in FIG. 6 in the shape of the light emitting region of the first sub-pixel 11. As shown in FIG. 10, the light emitting region of the first sub-pixel 11 includes four corners which have the same features, that is, the light emitting region of the first sub-pixel 11 shown in FIG. 10 does not include the specific corner 1014 shown in FIG. 6. For the display panel shown in FIG. 10, except that the shape of the light emitting region of the first sub-pixel is different from that of the first sub-pixel shown in FIG. 6, other features are the same as those of the display panel shown in FIG. 6, which will not be repeated here.

For example, the display panel shown in FIG. 11 is different from the display panel illustrated in Fig. 7 in the shape of the light-emitting region of the first sub-pixel 11. As illustrated in Fig. 11, the light-emitting region of the first sub-pixel 11 includes four corner portions which have the same features, that is, the light-emitting region of the first sub-pixel 11 illustrated in Fig. 11 does not include the specific corner portion 1014 illustrated in Fig. 7. For the display panel illustrated in Fig. 11, except that the shape of the light-emitting region of the first sub-pixel is different from that of the first sub-pixel illustrated in Fig. 7, other features are the same as those of the display panel illustrated in Fig. 7, which will not be repeated here.

For example, the display panel illustrated in Fig. 12 is different from the display panel illustrated in Fig. 8 in the shape of the light-emitting region of the first sub-pixel 11. As illustrated in Fig. 12, the light-emitting region of the first sub-pixel 11 includes four corner portions which have the same features, that is, the light-emitting region of the first sub-pixel 11 illustrated in Fig. 12 does not include the specific corner portion 1014 illustrated in Fig. 8. For the display panel illustrated in Fig. 12, except that the shape of the light-emitting region of the first sub-pixel is different from that of the first sub-pixel illustrated in Fig. 8, other features are the same as those of the display panel illustrated in Fig. 8, which will not be repeated here.

Fig. 13 is a schematic diagram of a first region of a display panel illustrated in Fig. 1 in still another example.

For example, the display panel illustrated in Fig. 13 is different from the display panel illustrated in Fig. 3 in that the portion, exposed by the second opening 320, of the first defining structure 511 (that is, the first defining partition portion 5011) has a different shape, the portion, exposed by the second opening 320, of the second defining structure 522 (that is, the second defining partition portion 5012) has a different shape, and the portion, exposed by the second opening 320, of the third defining structure 533 (that is, the third defining partition portion 5013) has a different shape.

For example, as illustrated in Fig. 13, the portion, exposed by the second opening 320, of the first defining structure 511 corresponding to the first sub-pixel 11 is a continuous structure, the portion, exposed by the second opening 320, of the second defining structure 522 corresponding to the second sub-pixel 12 is a continuous structure, and the portion, exposed by the second opening 320, of the third defining structure 533 corresponding to the third sub-pixel 13 is also a continuous structure. This arrangement is beneficial to partition at least one film layer in the light-emitting functional layer between adjacent sub-pixels, thus effectively reducing the risk of crosstalk.

At least one embodiment of the present disclosure further provides a display apparatus, which includes the display panel in any of the above examples. Other structures and functions of the display apparatus provided by the embodiment of the present disclosure can be realized by referring to the conventional technology, which is not limited by the embodiments of the present disclosure. For the technical effects of the display apparatus provided by the embodiment of the present disclosure, please refer to the above description of the technical effects of the display panel provided by the embodiment of the present disclosure, which will not be repeated here.

For example, the display apparatus may be a display device such as an organic light-emitting diode display apparatus, and any product or component with display function including the display apparatus such as a television, a digital camera, a mobile phone, a watch, a tablet computer, a laptop, and a navigator, which is not limited by this embodiment.

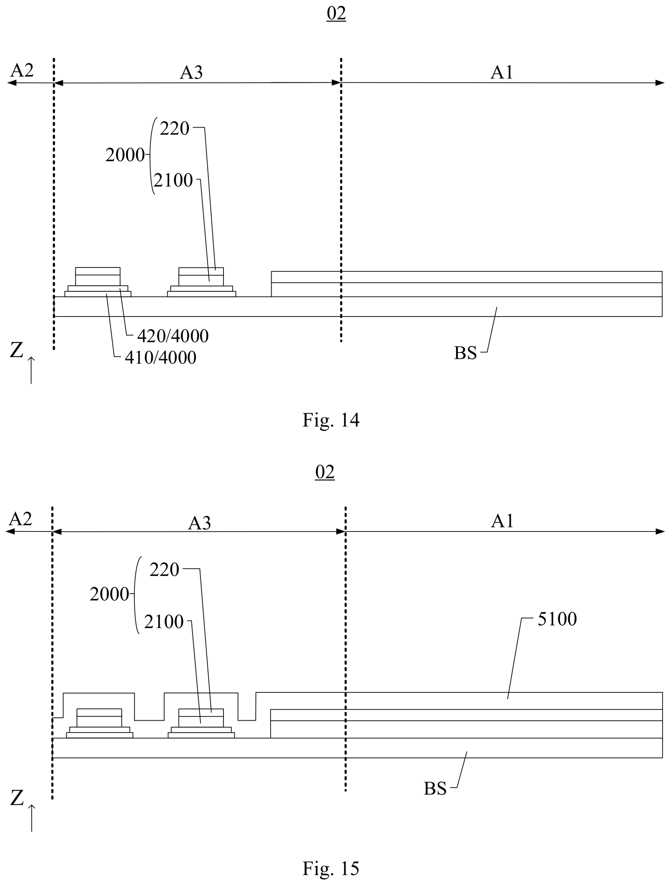

Fig. 14 to Fig. 20 are flowcharts of a manufacturing method of a display panel provided by an embodiment of the present disclosure.

At least one embodiment of the present disclosure further provides a manufacturing method of a display panel. For example, the manufacturing method is suitable for the display panel described in any of the above embodiments.

As illustrated in Fig. 14, a display panel 02 includes a first region A1, a second region A2, and a third region A3 located between the first region A1 and the second region A2, the first region A1 is configured to display, the second region A2 is configured to transmit light, and the first region A1 is located on at least one side of the second region A2. For example, the first region A1 is a display region configured to display. The second region A2 is a hollow region configured to transmit light. For example, hardware such as a photosensitive sensor may be arranged in the second region A2.

As illustrated in Fig. 14, the manufacturing method of the display panel 02 includes: performing patterning in the third region A3 to form an initial partition structure 2000 on a base substrate BS. The initial partition structure 2000 includes a first sub-isolation structure 2100 and a second isolation structure 220 which are arranged in a layered way, and the first sub-isolation structure 2100 is closer to the base substrate BS than the second isolation structure 220. In a direction perpendicular to the base substrate BS, an edge of the first sub-isolation structure 2100 is approximately flush with an edge of the second isolation structure 220. For example, a material of the first sub-isolation structure 2100 is different from that of the second isolation structure 220.

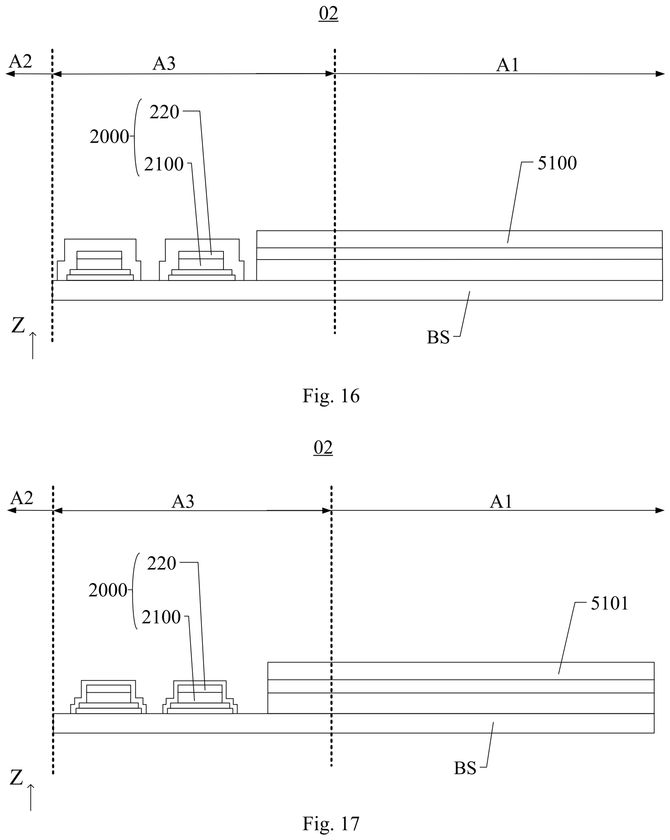

Next, as illustrated in Fig. 15 and Fig. 17, a first defining layer 5100 is formed on a side, away from the base substrate BS, of the initial partition structure 2000, and the first defining layer 5100 is patterned to form a first sub-defining portion 5101. In the third region A3, the first sub-defining portion 5101 covers a side surface of the initial partition structure 2000 and an upper surface, away from the base substrate BS, of the initial partition structure 2000. That is, in the third region A3, in response to the first defining layer 5100 being patterned, the portion located on the side surface of the initial partition structure 2000 and the upper surface, away from the base substrate BS, of the initial partition structure 2000 is preserved. The upper surface of the initial partition structure 2000 refers to a surface away from the base substrate BS, for example, the upper surface of the initial partition structure 2000 is basically parallel to the base substrate BS and perpendicular to a Z direction. Alternatively, a tangent plane of the upper surface of the initial partition structure 2000 is parallel to the base substrate BS and perpendicular to the Z direction.

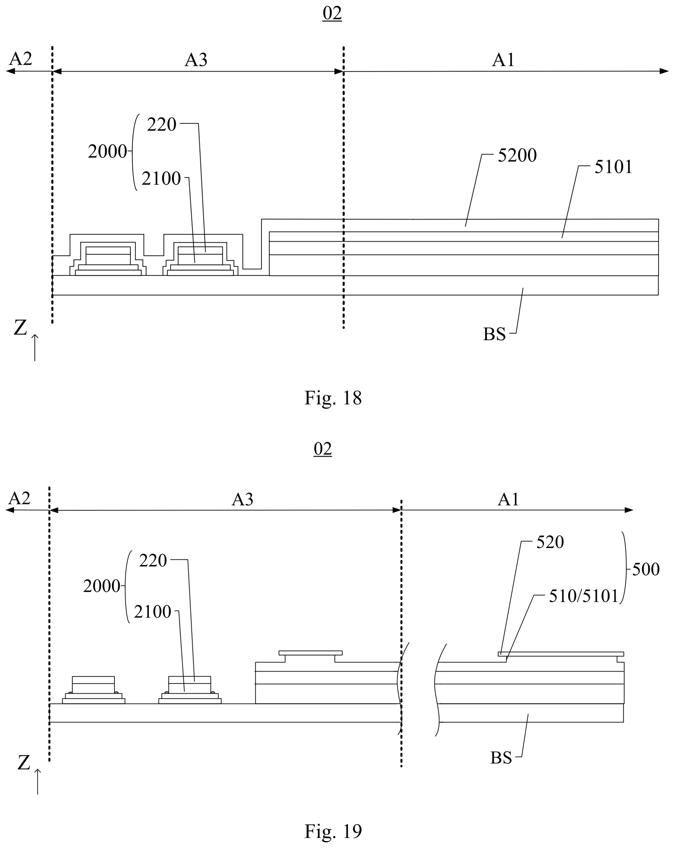

Further, as illustrated in Fig. 18 and Fig. 19, a second defining layer 5200 is formed on a side, away from the base substrate BS, of the first sub-defining portion 5101, and the second defining layer 5200 and the first sub-defining portion 5101 are patterned to expose at least a portion of the initial partition structure 2000. In response to the second defining layer 5200 being patterned, a portion, located in the third region A3, of the second defining layer 5200 is largely removed, and a portion, located in the first region A1, of the second defining layer 5200 is patterned to form a second sub-defining structure 520. In response to the first sub-defining portion 5101 is patterned, a portion, located in the third region A3, of the first sub-defining portion 5101 is largely removed, and a portion, located in the first region A1, of the first sub-defining portion 5101 is patterned to form a first sub-defining structure 510. For example, the first sub-defining portion 5101 and the second defining layer 5200 may be etched simultaneously by dry etching.

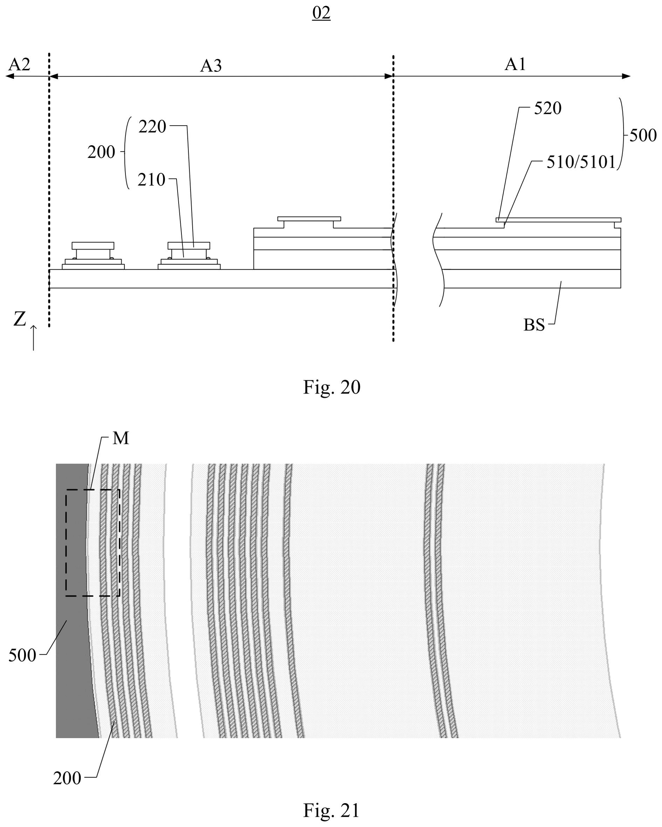

Finally, as illustrated in Fig. 19 and Fig. 20, the initial partition structure 2000 is patterned to form a partition structure 200. The partition structure 200 includes a first isolation structure 210 and a second isolation structure 220 which are arranged in a layered way. The second isolation structure 220 is located on a side, away from the base substrate BS, of the first isolation structure 210, and an edge of the second isolation structure 220 protrudes relative to an edge of the first isolation structure 210. The partition structure 200 is configured to partition at least one film layer of a light-emitting functional layer of a sub-pixel 10. In the third region A3, a side wall of at least one partition structure 200 is covered with at least one of at least a portion of the second defining layer 5200 (as illustrated in Fig. 18) and at least a portion of the first sub-defining portion 5101.

For example, as illustrated in Fig. 19 and Fig. 20, in response to the initial partition structure 2000 being patterned, the first sub-isolation structure 2100 may be etched by wet etching, so that an edge of the first sub-isolation structure 2100 retracts inward relative to the edge of the second isolation structure 220, thereby enabling the formed partition structure 200 to have an "undercut" structure, so as to partition at least one film layer in the subsequently formed light-emitting functional layer.

Considering the precision of the actual manufacturing process, as illustrated in Fig. 18 to Fig. 20, in the process of patterning the first sub-defining portion 5101 and the second defining layer 5200, at least one of at least the portion of the first sub-defining portion 5101 and at least the portion of the second defining layer 5200 is difficult to be completely removed in the third region A3, so a portion remains on the side wall of the initial partition structure 2000. Finally, as illustrated in Fig. 20, in response to the initial partition structure 2000 being patterned, at least one of at least the portion of the first sub-defining portion 5101 and at least the portion of the second defining layer 5200 remains on the side wall of the partition structure 200.

For example, as illustrated in Fig. 15 to Fig. 20, a portion, covering the side surface and the upper surface of the initial partition structure 2000, of the first defining layer 5100 can play an isolation role. After other structures are patterned, the first defining layer 5100 covering the side surface and the upper surface of the initial partition structure 2000 is removed, and finally the initial partition structure 2000 is patterned to form the partition structure 200. Therefore, the influence of other film layers on the partition structure 200 can be reduced, for example, it is possible to prevent at least a portion of other film layers (that is, the second defining layer 5200) from filling the "undercut" structure of the partition structure 200, which makes it difficult for the partition structure 200 to perform the function of partition.

The manufacturing method of the display panel provided by the embodiment of the present disclosure is simple and easy to implement, which make the manufacturing process of the partition structure 200 is easy to control, and the portion of the partition structure 200 that is intended to perform partition is not covered or filled by other film layers, the edge of the second isolation structure 220 in the partition structure 200 protrudes relative to the edge of the first isolation structure 210, which enables the second isolation structure 220 in the partition structure 200 to have an obvious protrusion portion, thereby reducing the risk of crosstalk.

For example, as illustrated in Fig. 15 and Fig. 16, patterning the first defining layer 5100 to form the first sub-defining portion 5101 includes: removing a portion, between adjacent initial partition structures 2000, of the first defining layer 5100 in the third region A3. At this point, as illustrated in Fig. 16, at least a portion of the first defining layer 5100 covers the side surface and the upper surface of the initial partition structure 200, and the thickness of this portion is large, which is basically equal to the thickness of a portion, located in the first region A1, of the first defining layer 5100. Then, as illustrated in Fig. 16 and Fig. 17, the portion, covering the side surface and the upper surface of the initial partition structure 2000, of the first defining layer 5100 is thinned. At this point, in the third region A3, the thickness of a portion, covering the side surface and the upper surface of the initial partition structure 2000, of the first sub-defining portion 5101 is smaller than that of a portion, located in the first region A1, of the first sub-defining portion 5101.

For example, as illustrated in Fig. 15 to Fig. 17, in the third region A3, the first defining layer 5100 may be patterned with a halftone mask, so as to thin the portion, covering the side surface and the upper surface of the initial partition structure 2000, of the first defining layer 5100 while removing the portion, between adjacent initial partition structures 2000, of the first defining layer 5100, so that the thickness of the first defining layer 5100 after thinning is 100 to 10000 Å. For example, the mask used for patterning the first defining layer 5100 has different transmittances in different regions. For example, in the third region A3, the transmittance of a portion, between two adjacent initial partition structures 2000, of the mask is 100%, so that the portion, between adjacent initial partition structures 2000, of the first defining layer 5100 is completely removed after exposure. For example, the transmittance of a portion, covering the side surface and the upper surface of the initial partition structure 2000, of the mask is 40% to 90%, such as at least one of 40% to 50%, 45% to 55%, 60% to 70%, 65% to 75%, 80% to 85% and 85% to 90%, so that the portion, covering the side surface and the upper surface of the initial partition structure 2000, of the first defining layer 5100 is thinned after exposure. For example, the thickness of this portion of the first defining layer 5100 after thinning is at least one of 100 to 1000 Å, 500 to 1500 Å, 1200 to 1800 Å, 2000 to 2500 Å, 3000 to 3500 Å, 4000 to 6000 Å and 7000 to 8000 Å.

For example, as illustrated in Fig. 15 to Fig. 17, in response to thinning the portion, covering the side surface and the upper surface of the initial partition structure 2000, of the first defining layer 5100, the portion of the first defining layer 5100 that needs to be removed subsequently in the first display region A1 will be thinned too (not illustrated in the figure), so as to improve the patterning degree of the portion, located in the first display region A1, of the first defining layer 5100.

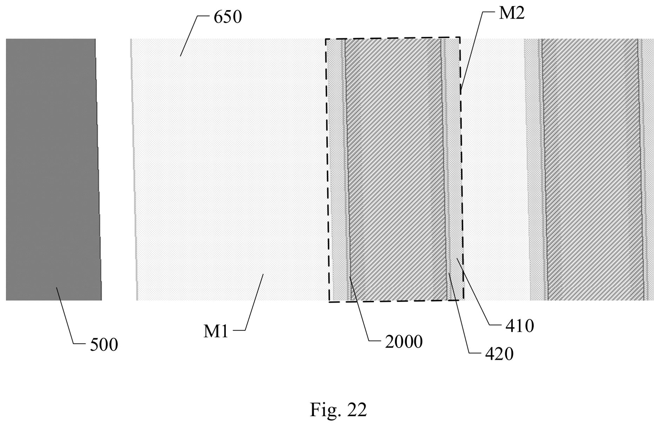

Fig. 21 is a partial plan structural view of a display panel provided by an embodiment of the present disclosure. Fig. 22 is a partial enlarged structural view of a region in Fig. 21.

For example, as illustrated in Fig. 21, the display panel includes a plurality of initial partition structures 2000 arranged at intervals. One side of the initial partition structure 2000 is provided with a defining structure 500 to partition at least one film layer of the light-emitting functional layer.

For example, as illustrated in Fig. 15 to Fig. 17 and Fig. 22, the first defining layer 5100 may be patterned with a halftone mask 650, and the transmittance of a portion M1, between adjacent initial partition structures 2000, of the halftone mask 650 is 100%, so that the portion, between adjacent initial partition structures 2000, of the first defining layer 5100 is completely removed after exposure. For example, a portion, covering the side surface and the upper surface of the initial partition structure 2000, of the halftone mask 650 is M2, and the transmittance of M2 is 40% to 90%, so that the portion, covering the side surface and the upper surface of the initial partition structure 2000, of the first defining layer 5100 is thinned after exposure.

For example, as illustrated in Fig. 18, the formed second defining layer 5200 and the formed first sub-defining portion 5101 each include a portion located in the first region A1. The portion, in the first region A1, of the first sub-defining portion 5101 is located on the base substrate BS, and the portion, located in the third region A3, of the first sub-defining portion 5101 covers the side surface and the upper surface of the initial partition structure 2000. For example, the portions of the second defining layer 5200 located in the first region A1 and the third region A3 are continuous film layers, and the portions of the second defining layer 5200 located in the first region A1 and the third region A3 are integrally arranged.

For example, as illustrated in Fig. 18 and Fig. 19, patterning the second defining layer 5200 and the first sub-defining portion 5101 to expose the initial partition structure 2000 includes: patterning the second defining layer 5200 and the first sub-defining portion 5101 at the same time, so as to, while forming the defining structure 500 in the first region A1, remove the second defining layer 5200 in the third region A3 and remove at least portion of the first sub-defining portion 5101 covering the side surface and the upper surface of the initial partition structure 200.

For example, as illustrated in Fig. 18 and Fig. 19, in response to the second defining layer 5200 being patterned, the portion, located in the first region A1, of the second defining layer 5200 is patterned to form a second sub-defining structure 520, and the portion, located in the third region A3, of the second defining layer 5200 is largely removed after patterning. For example, the first sub-defining portion 5101 and the second defining layer 5200 are patterned at the same time, the portion, located in the first display region A1, of the first sub-defining portion 5101 is patterned to form a first sub-defining structure 510, and the portion, located in the third region A3, of the first sub-defining portion 5101 is largely removed. For example, because of the limitation of process precision, in the third region A3, at least one of at least a portion of the first sub-defining portion 5101 and at least a portion of the second defining layer 5200 remains on the side wall of the initial partition structure 2000.

As illustrated in Fig. 19, in the first region A1, the defining structure 500 includes a first sub-defining structure 510 and a second sub-defining structure 520, which are arranged in a layered way. The first sub-defining structure 510 is located at a side, close to the base substrate BS, of the second sub-defining structure 520, and an edge of the second sub-defining structure 520 protrudes relative to an edge of the first sub-defining structure 510, so that the defining structure 500 can be configured to partition at least one film layer in the light-emitting functional layer located between adjacent sub-pixels.

For example, as illustrated in Fig. 18 and Fig. 19, in the third region A3, a portion, covering the upper surface of the initial partition structure 2000, of the first sub-defining portion 5101 is removed, and a portion, covering a side surface of the first sub-isolation structure 2100 in the initial partition structure 2000, of the first sub-defining portion 5101 is largely removed. For example, in the third region A3, at least a portion of the first sub-defining portion 5101 remains on the side surface of the first sub-isolation structure 2100 in the initial partition structure 2000. For example, a certain distance exists between the portion, remaining on the side surface of the first sub-isolation structure 2100, of the first sub-defining portion 5101 and the second isolation structure 220 in the Z direction, which facilitates the formation of an "undercut" structure of the initial partition structure 2000.

For example, as illustrated in Fig. 14, before the initial partition structure 2000 is formed on the base substrate BS, the manufacturing method of the display panel 02 further includes: in the third region A3, performing patterning to form at least one layer of metal structure 4000. The metal structure 4000 and the initial partition structure 200 are arranged in a layered way, the metal structure 4000 is closer to the base substrate BS than the initial partition structure 200, and an orthographic projection of the initial partition structure 2000 on the base substrate BS falls within an orthographic projection of the metal structure 4000 on the base substrate BS.

The display panel illustrated in Fig. 14 includes a first metal structure 410 and a second metal structure 420. The first metal structure 410, the second metal structure 420 and the initial partition structure 2000 are sequentially arranged in a layered way in the Z direction, and the initial partition structure 2000 is located at a side, away from the base substrate BS, of the second metal structure 420. For example, the first metal structure 410 and the second metal structure 420 may adopt different metal materials, and the first metal structure 410 is located at a side, close to the base substrate BS, of the second metal structure 420. For example, the first metal structure 410 and the second metal structure 420 may make the initial partition structure 2000 and the base substrate BS spaced apart from each other, and make the initial partition structure 2000 "raised", thus improving the exposure effect in the process of forming the initial partition structure 2000.

For example, as illustrated in Fig. 16 and Fig. 17, patterning the first defining layer 5100 to form the first sub-defining portion 5101 further includes: thinning a portion, covering a surface of the metal structure 4000, of the first defining layer 5100 in the third region A3. For example, at least a portion of the first defining layer 5100 covers the surface of the metal structure 4000, and the thickness is reduced during the patterning process. For example, as illustrated in Fig. 17, after the first defining layer 5100 is patterned, at least a portion of the first defining layer 5100 covers a surface of a stacked structure formed by the first metal structure 410, the second metal structure 420 and the initial partition structure 2000.

For example, as illustrated in Fig. 18 and Fig. 19, patterning the second defining layer 5200 and the first sub-defining portion 5101 to expose the initial partition structure 2000 further includes: patterning the second defining layer 5200 and the first sub-defining portion 5101 at the same time, so that the portion, covering the surface of the metal structure 4000, of the first defining layer 5100 is preserved in the third region A3. For example, as illustrated in Fig. 19, after patterning, the portion, covering the upper surface and the side surface of the initial partition structure 2000, of the first sub-defining portion 5101 is largely removed, and at least a portion of the first sub-defining portion 5101 covers the surface of the metal structure 4000. With this arrangement, the metal structure 4000 can be isolated from the light-emitting functional layer to reduce the risk of crosstalk.

For example, as illustrated in Fig. 2, the manufacturing method of the display panel provided by the embodiment of the present disclosure may include: preparing the base substrate BS on a glass carrier plate. For example, the base substrate BS may be a flexible base substrate. For example, the forming the base substrate BS may include sequentially forming a first flexible material layer, a first inorganic material layer, a semiconductor layer, a second flexible material layer, and a second inorganic material layer stacked on the glass carrier plate. The first flexible material layer and the second flexible material layer are made of polyimide (PI), polyethylene terephthalate (PET), or surface-treated polymer soft films. For example, the first inorganic material layer and the second inorganic material layer are made of silicon nitride (SiNx) or silicon oxide (SiOx), etc., to improve water oxygen resistance ability of the base substrate; and the first inorganic material layer and the second inorganic material layer are also referred to as barrier layers.

For example, as illustrated in Fig. 2, the manufacturing method of the display panel provided by the embodiment of the present disclosure may include: forming a driving structure layer of a pixel circuit on the base substrate BS. The driving structure layer includes a plurality of pixel circuits; each pixel circuit includes a plurality of transistors and at least one storage capacitor; for example, the pixel circuit may adopt design of 2T1C, 3T1C or 7T1C. For example, forming the driving structure layer may include: sequentially depositing a first insulation thin film and an active layer thin film on the base substrate BS, and patterning the active layer thin film by using a patterning process, to form a first insulation layer covering the entire base substrate BS, and an active layer pattern provided on the first insulation layer; the active layer pattern at least including an active layer. For example, a second insulation thin film and a first metal thin film are sequentially deposited, and the first metal thin film is patterned by using a patterning process, to form a second insulation layer covering the active layer pattern, and a first gate metal layer pattern provided on the second insulation layer; and the first gate metal layer pattern at least includes a gate electrode and a first capacitor electrode. For example, a third insulation thin film and a second metal thin film are sequentially deposited, and the second metal thin film is patterned by using a patterning process, to form a third insulation layer covering the first gate metal layer, and a second gate metal layer pattern provided on the third insulation layer; the second gate metal layer pattern at least includes a second capacitor electrode; and a position of the second capacitor electrode corresponds to a position of the first capacitor electrode. Subsequently, a fourth insulation thin film is deposited; the fourth insulation thin film is patterned by using a patterning process, to form a fourth insulation layer covering the second gate metal layer; at least two via holes are opened in the fourth insulation layer; and the fourth insulation layer, the third insulation layer and the second insulation layer inside the two via holes are etched away, to expose a surface of the active layer in the active layer pattern. Subsequently, a third metal thin film is deposited, and the third metal thin film is patterned by using a patterning process, to form a source-drain metal layer pattern in the fourth insulation layer; and the source-drain metal layer pattern at least includes a source electrode and a drain electrode located in a display region. The source electrode and the drain electrode may be respectively connected with the active layer in the active layer pattern through the via holes.

For example, the first insulation layer, the second insulation layer, the third insulation layer and the fourth insulation layer as described above may be made of any one or more of silicon oxide (SiOx), silicon nitride (SiNx), and silicon oxynitride (SiON), which may be a single-layer structure, a multi-layer structure, or a composite-layer structure. The first insulation layer may be a buffer layer used for improving water oxygen resistance ability of the base substrate BS. The second insulation layer and the third insulation layer may be gate insulator (GI) layers. The fourth insulation layer may be an interlayer dielectric (ILD) layer. The first metal thin film, the second metal thin film and the third metal thin film are made of metal materials, for example, any one or more of silver (Ag), copper (Cu), aluminum (Al), titanium (Ti), and molybdenum (Mo), or alloy materials of the above-described metals, for example, an aluminum neodymium alloy (AlNd) or a molybdenum niobium alloy (MoNb), which may be a single-layer structure or a multi-layer composite structure, for example, Ti/Al/Ti, etc. The active layer thin film is made of one or more materials such as amorphous indium gallium zinc oxide (a-IGZO), zinc nitride oxide (ZnON), indium zinc tin oxide (IZTO), amorphous silicon (a-Si), polycrystalline silicon (p-Si), hexathiophene, polythiophene, etc., that is, the present disclosure is applicable to transistors manufactured based on oxide technologies, silicon technologies, and organic technologies.

For example, as illustrated in Fig. 2, after the partition structure 200 is formed, the manufacturing method of the display panel provided by the embodiment of the present disclosure further includes: patterning on the defining structure 500 to form a first electrode 110. For example, the first electrode 110 may be made of any one or more of metal materials, for example, magnesium (Mg), silver (Ag), copper (Cu), aluminum (Al), titanium (Ti) and molybdenum (Mo), or alloy materials of the above-described metals, for example, an aluminum neodymium alloy (AlNd) or a molybdenum niobium alloy (MoNb), which may be a single-layer structure, or a multi-layer composite structure, for example, Ti/Al/Ti, or a stack structure formed by metal and transparent conductive materials, for example, reflective materials such as ITO/Ag/ITO, Mo/AlNd/ITO, etc. For example, the first electrode 110 is electrically connected with the pixel circuit through a connection via hole N1.

For example, as illustrated in Fig. 2, after the first electrode 110 is formed, a pixel defining pattern 300 may be formed. For example, a pixel defining film is coated on the base substrate BS on which the aforementioned pattern is formed, and the pixel defining pattern 300 is formed through masking, exposure and development processes. For example, the pixel defining pattern 300 in the display region includes a first opening 310 and a second opening 320 (please refer to Fig. 4), the pixel defining films in the first opening 310 and the second opening 320 are removed by development, at least a portion of a surface of the first electrode 110 of each of a plurality of sub-pixels is exposed by the first opening 310, and the defining structure 500 is exposed by the second opening 320.

For example, as illustrated in Fig. 2, after forming the pixel defining pattern 300, a spacer may be formed on the pixel defining pattern 300. For example, an organic material thin film is coated on the base substrate BS on which the foregoing pattern is formed; and the spacer is formed by using masking, exposure, and development processes. The spacer may serve as a support layer, and is configured to support a fine metal mask (FMM) in an evaporation process.

For example, as illustrated in Fig. 2, after forming the spacer, the light-emitting functional layer 130 and the second electrode 120 are sequentially formed. For example, the second electrode 120 may be a transparent cathode. The light-emitting functional layer 130 may emit light from a side away from the base substrate BS through the transparent cathode, to implement top emission. For example, the second electrode 120 may be made of any one or more of magnesium (Mg), silver (Ag), aluminum (Al), or alloys made of any one or more of the above-described metals, or transparent conductive materials, for example, indium tin oxide (ITO), or a multi-layer composite structure of metals and transparent conductive materials.

For example, as illustrated in Fig. 2, the forming the light-emitting functional layer 130 may include: sequentially evaporating with an open mask to form a hole injection layer and a hole transport layer; sequentially evaporating with a fine metal mask (FMM) to form a first light-emitting layer 131 that emits light of different colors, for example, a blue light-emitting layer, a green light-emitting layer, or a red light-emitting layer; sequentially evaporating with an open mask to form an electron transport layer, a charge generation layer 133, and a hole transport layer; sequentially evaporating with a fine metal mask (FMM) to form a second light-emitting layer 132 that emits light of different colors, for example, a blue light-emitting layer, a green light-emitting layer, or a red light-emitting layer; and sequentially evaporating with an open mask to form an electron transport layer, a second electrode 120 and a capping layer. For example, the hole injection layer, the hole transport layer, the electron transport layer, the charge generation layer, the second electrode 120 and the capping layer are all common layers of the plurality of sub-pixels.

For example, as illustrated in Fig. 2, in the first region A1, the formed light-emitting functional layer 130 is disconnected at an edge of the defining structure 500, thereby reducing a risk of crosstalk between adjacent sub-pixels. In the third region A3, the formed light-emitting functional layer 130 will be disconnected at an edge of the partition structure 200, thereby further reducing a risk of crosstalk between sub-pixels located in the vicinity of the edge of the first region A1.

For example, after forming the second electrode 120, the manufacturing method of the display panel further includes: forming an encapsulation layer; in which the encapsulation layer may include a first encapsulation layer, a second encapsulation layer, and a third encapsulation layer stacked. The first encapsulation layer is made of an inorganic material and covers the second electrode 120 in the display region. The second encapsulation layer is made of an organic material. The third encapsulation layer is made of an inorganic material, and covers the first encapsulation layer and the second encapsulation layer. However, this will not be limited in this embodiment. For example, the encapsulation layer may also adopt a five-layer structure of inorganic/organic/inorganic/organic/inorganic.

The following statements should be noted:
(1) The accompanying drawings related to the embodiment(s) of the present disclosure involve only the structure(s) in connection with the embodiment(s) of the present disclosure, and other structure(s) can be referred to common design(s).
(2) In case of no conflict, features in one embodiment or in different embodiments of the present disclosure can be combined.

The foregoing is merely exemplary embodiments of the disclosure, but is not used to limit the protection scope of the disclosure. The protection scope of the disclosure shall be defined by the attached claims.

## Claims

1. A display panel, comprising:
a first region, configured to display;
a second region, configured to transmit light, the first region being located on at least one side of the second region;
a third region, located between the first region and the second region;
a plurality of sub-pixels, located in the first region, each sub-pixel of at least some sub-pixels comprising a light-emitting functional layer, and the light-emitting functional layer comprising a plurality of film layers; and
a base substrate, and at least one partition structure located on the base substrate, the partition structure being located in the third region and comprising a first isolation structure and a second isolation structure which are arranged in a layered way, the second isolation structure being located on a side of the first isolation structure away from the base substrate, an edge of the second isolation structure protruding relative to an edge of the first isolation structure, and the partition structure being configured to partition at least one layer of the light-emitting functional layer;
wherein the display panel further comprises an insulation layer located on the base substrate, and in the third region, at least a portion of the insulation layer is located on a side wall of the at least one partition structure.

2. The display panel according to claim 1, wherein
the second isolation structure comprises a protrusion portion which protrudes relative to the edge of the first isolation structure, and the at least a portion of the insulation layer located on the side wall of the partition structure and the protrusion portion of the partition structure are spaced apart from each other in a direction perpendicular to the base substrate.

3. The display panel according to claim 1 or 2, wherein at least a portion of the insulation layer is located on a side wall of the first isolation structure; and/or
the partition structure further comprises a third isolation structure located on a side of the first isolation structure close to the base substrate, and at least a portion of the insulation layer is located on a side wall of the third isolation structure.

4. The display panel according to claim 1 or 2, wherein the partition structure further comprises a third isolation structure located on a side of the first isolation structure close to the base substrate, the first isolation structure, the second isolation structure and the third isolation structure all comprise metal materials,
the material of the first isolation structure is different from that of the second isolation structure, and the material of the second isolation structure is the same as that of the third isolation structure; or
the materials of the first isolation structure, the second isolation structure and the third isolation structure are different.

5. The display panel according to any one of claims 1-4, further comprising at least one layer of metal structure located between the partition structure and the base substrate, and
in the third region, an orthographic projection of the partition structure on the base substrate falls within an orthographic projection of the at least one layer of metal structure on the base substrate.

6. The display panel according to claim 5, wherein the at least one layer of metal structure comprises a first metal structure and a second metal structure which are arranged in a layered way; and
in the third region, the first metal structure, the second metal structure and the partition structure are sequentially arranged in a layered way in a direction perpendicular to the base substrate, and the partition structure is located on a side of the second metal structure away from the base substrate.

7. The display panel according to claim 6, wherein the orthographic projection of the partition structure on the base substrate falls within an orthographic projection of the second metal structure on the base substrate.

8. The display panel according to claim 6 or 7, further comprising:
a pixel defining pattern, located in the first region and on the base substrate, the pixel defining pattern comprising a plurality of first openings to define light-emitting regions of at least some of the sub-pixels; and
a defining structure, located in the first region and between the light-emitting functional layer and the base substrate, the defining structure comprising a portion surrounding the light-emitting region of each of the at least some of the sub-pixels,
wherein the pixel defining pattern further comprises a second opening, a portion of at least one layer of the light-emitting functional layer located in the first opening is a continuous portion, at least a portion of the at least one layer of the light-emitting functional layer located in at least one second opening is partitioned, and a portion exposed by the second opening in the defining structure is configured to partition the at least one layer of the light-emitting functional layer.

9. The display panel according to claim 8, wherein the defining structure comprises a first sub-defining structure and a second sub-defining structure which are arranged in a layered way, the first sub-defining structure is located at a side of the second sub-defining structure close to the base substrate, and an edge of the second sub-defining structure protrudes relative to an edge of the first sub-defining structure; and
a portion, located in the first region, of the insulation layer comprises at least one of the first sub-defining structure and the second sub-defining structure.

10. The display panel according to claim 9, wherein the portion, located in the first region, of the insulation layer comprises the first sub-defining structure, and at least a portion of the insulation layer covers an outer wall of the first metal structure and an outer wall of the second metal structure.

11. The display panel according to claim 10, wherein an average thickness of the portion, covering the outer wall of the first metal structure and the outer wall of the second metal structure, of the insulation layer is a first thickness, an average thickness of the first sub-defining structure located in the first region of the insulation layer is a second thickness, and the first thickness is smaller than the second thickness.

12. The display panel according to claim 11, wherein the first thickness is 1/100 to 1/10 of the second thickness.

13. The display panel according to any one of claims 1-12, wherein the display panel comprises a plurality of partition structures arranged at intervals, and the partition structure has a shape of a ring and surrounds the second region; and
in the third region, at least a portion of the base substrate between adjacent partition structures is not overlapped with the insulation layer.

14. The display panel according to any one of claims 9-12, wherein
each of the at least some sub-pixels further comprises a first electrode and a second electrode which are located on two sides of the light-emitting functional layer in a direction perpendicular to the base substrate, the first electrode is located between the light-emitting functional layer and the base substrate, the pixel defining pattern is located on a side of the first electrode away from the base substrate, and the second sub-defining structure is located between the first electrode and the base substrate; and
the display panel further comprises a pixel circuit located on a side of the first sub-defining structure close to the base substrate, and the pixel circuit is electrically connected with the first electrode.

15. The display panel according to claim 14, wherein a film layer where the first sub-defining structure is located comprises a connection via hole, the pixel circuit is electrically connected with the first electrode through the connection via hole, and at least a portion of the second sub-defining structure extends into the connection via hole and covers a side wall of the connection via hole.

16. The display panel according to any one of claims 9-15, wherein a material of the first sub-defining structure is different from that of the second sub-defining structure, the material of the first sub-defining structure includes an organic material or an inorganic non-metallic material, and the material of the second sub-defining structure includes an inorganic non-metallic material or a metallic material.

17. The display panel according to any one of claims 9-16, wherein for a same etching solution, an etching selectivity of the first isolation structure, an etching selectivity of the first sub-defining structure and an etching selectivity of the second sub-defining structure decrease in sequence.

18. A display apparatus, comprising the display panel according to any one of claims 1-17.

19. A manufacturing method of a display panel, wherein the display panel comprises a first region, a second region and a third region located between the first region and the second region, the first region is configured to display, the second region is configured to transmit light, and the first region is located on at least one side of the second region; and
the manufacturing method comprises:
patterning to form an initial partition structure in the third region on a base substrate, the initial partition structure comprising a first sub-isolation structure and a second isolation structure which are arranged in a layered way, the first sub-isolation structure being closer to the base substrate than the second isolation structure, and in a direction perpendicular to the base substrate, an edge of the first sub-isolation structure being approximately flush with an edge of the second isolation structure;
forming a first defining layer on a side of the initial partition structure away from the base substrate, and patterning the first defining layer to form a first sub-defining portion, and in the third region, the first sub-defining portion covering a side surface of the initial partition structure and an upper surface of the initial partition structure away from the base substrate;
forming a second defining layer on a side of the first sub-defining portion away from the base substrate, and patterning the second defining layer and the first sub-defining portion to expose at least a portion of the initial partition structure; and
patterning the initial partition structure to form a partition structure,
wherein the partition structure comprises a first isolation structure and a second isolation structure which are arranged in a layered way, the second isolation structure is located on a side of the first isolation structure away from the base substrate, an edge of the second isolation structure protrudes relative to an edge of the first isolation structure, the partition structure is configured to partition at least one layer of a light-emitting functional layer of a sub-pixel, and
in the third region, a side wall of at least one partition structure is covered with at least one of at least a portion of the second defining layer and at least a portion of the first sub-defining portion.

20. The manufacturing method according to claim 19, wherein patterning the first defining layer to form a first sub-defining portion comprises:
in the third region, removing a portion of the first defining layer between adjacent initial partition structures; and thinning a portion of the first defining layer covering the side surface and the upper surface of the initial partition structure.

21. The manufacturing method according to claim 20, wherein in the third region, the first defining layer is patterned with a halftone mask, so as to thin the portion of the first defining layer covering the side surface and the upper surface of the initial partition structure while removing the portion of the first defining layer between adjacent initial partition structures, and a thickness of the first defining layer after thinning is 100-10000 Å.

22. The manufacturing method according to claim 20 or 21, wherein both of the second defining layer and the first sub-defining portion which are formed comprise a portion located in the first region, and patterning the second defining layer and the first sub-defining portion to expose the initial partition structure comprises:
patterning the second defining layer and the first sub-defining portion at the same time, so as to remove the second defining layer in the third region while forming a defining structure in the first region, and remove at least a portion of the first sub-defining portion covering the side surface and the upper surface of the initial partition structure,
wherein the defining structure comprises a first sub-defining structure and a second sub-defining structure which are arranged in a layered way, the first sub-defining structure is located at a side of the second sub-defining structure close to the base substrate, and an edge of the second sub-defining structure protrudes relative to an edge of the first sub-defining structure.

23. The manufacturing method according to claim 22, wherein in the third region, a portion of the first sub-defining portion covering the upper surface of the initial partition structure is removed, and a portion of the first sub-defining portion covering a side surface of the first sub-isolation structure in the initial partition structure is basically removed.

24. The manufacturing method according to claim 22 or 23, wherein before forming the initial partition structure on the base substrate, the manufacturing method further comprises:
performing patterning to form at least one layer of metal structure in the third region, wherein the metal structure and the initial partition structure are arranged in a layered way, the metal structure is closer to the base substrate than the initial partition structure, and an orthographic projection of the initial partition structure on the base substrate falling within an orthographic projection of the metal structure on the base substrate.

25. The manufacturing method according to claim 24, wherein
patterning the first defining layer to form the first sub-defining portion further comprises: thinning a portion of the first defining layer covering a surface of the metal structure in the third region; and
patterning the second defining layer and the first sub-defining portion to expose the initial partition structure further comprises: patterning the second defining layer and the first sub-defining portion at the same time, so that the portion of the first defining layer covering the surface of the metal structure is preserved in the third region.
